# EUROPEAN PATENT APPLICATION

(11) **EP 4 637 276 A1**
(43) Date of publication of application: **22.10.2025**
(21) Application number: 23941299.2
(22) Date of filing: 31.10.2023
(51) Int. Cl.: H05K 1/02, H01M 50/519

(54) **INTEGRATED CIRCUIT BOARD, BATTERY MODULE, ELECTRONIC DEVICE, AND INTEGRATED CIRCUIT BOARD MANUFACTURING METHOD**

(30) Priority: 14.06.2023 CN 202310704602
(71) Applicant: Honor Device Co., Ltd., Shenzhen, Guangdong 518040 (CN)
(72) Inventor: HUANG, Qiuyu, Shenzhen, Guangdong 518040 (CN); DING, Caihua, Shenzhen, Guangdong 518040 (CN)
(74) Representative: Gill Jennings & Every LLP
(86) International application number: PCT/CN2023/128330
(87) International publication number: WO 2024/255075

(57) **Abstract**

This application provides an integrated circuit board, a battery module, an electronic device, and an integrated circuit board preparation method. The integrated circuit board includes a flexible circuit board, a first electrical component, a second electrical component, a connecting member, a reinforcing plate, and a packaging member. The flexible circuit board includes a body part and an extension part that are connected in a length direction of the integrated circuit board. The first electrical component and the second electrical component are respectively disposed on two opposite sides of the body part. The connecting member and the reinforcing plate are respectively disposed on two opposite sides of the extension part. In a thickness direction of the integrated circuit board, a projection of the reinforcing plate on the extension part and a projection of the connecting member on the extension part overlap at least partially. The packaging member is fastened to the body part, and the packaging member completely covers the first electrical component. In the thickness direction of the integrated circuit board, both a projection of the second electrical component and a projection of the body part are completely located on the packaging member. The thickness of the integrated circuit board is reduced, which facilitates lightweight design of the electronic device.

## Description

This application claims priority to Chinese Patent Application No. 202310704602.4, filed with the China National Intellectual Property Administration on June 14, 2023 and entitled "INTEGRATED CIRCUIT BOARD, BATTERY MODULE, ELECTRONIC DEVICE, AND INTEGRATED CIRCUIT BOARD PREPARATION METHOD", which is incorporated herein by reference in its entirety.

### TECHNICAL FIELD

This application relates to the field of circuit board technologies, and in particular, to an integrated circuit board, a battery module, an electronic device, and an integrated circuit board preparation method.

### BACKGROUND

Currently, various electronic devices are widely used, and a battery is an indispensable component regardless of the types of electronic devices. In a current electronic device, to improve battery security, an integrated circuit board is disposed on the battery, so as to protect the battery and control the battery to stop working in a case in which the battery is overloaded, overcharged, or the like.

However, with the development of lightweight electronic devices, a size of an integrated circuit board has become a bottleneck that restricts lightweight design of electronic devices.

### SUMMARY

This application provides an integrated circuit board, a battery module, an electronic device, and an integrated circuit board preparation method. A size of the integrated circuit board is reduced, which facilitates lightweight design of the electronic device.

A first aspect of this application provides an integrated circuit board, including a flexible circuit board, a first electrical component, a second electrical component, a connecting member, a reinforcing plate, and a packaging member. The flexible circuit board includes a body part and an extension part that are connected in a length direction of the integrated circuit board; the first electrical component and the second electrical component are respectively disposed on two sides of the body part that are opposite in a thickness direction of the integrated circuit board; the connecting member and the reinforcing plate are respectively disposed on two sides of the extension part that are opposite in the thickness direction of the integrated circuit board; and in the thickness direction of the integrated circuit board, a projection of the reinforcing plate on the extension part and a projection of the connecting member on the extension part overlap at least partially; and the packaging member is fastened to the body part, the packaging member completely covers the first electrical component, and in the thickness direction of the integrated circuit board, both a projection of the second electrical component and a projection of the body part are completely located on the packaging member. The first reinforcing plate supports the first connecting member, so as to reduce a risk of pin deformation of the first connecting member.

In this application, a thickness of the thickest area of the integrated circuit board in the Z-axis direction is a sum of a thickness dimension of the packaging member, a thickness dimension of the flexible circuit board, and a thickness dimension of the second electrical component. In a first conventional technology, the integrated circuit board generally includes a printed circuit board, a flexible circuit board, and a packaging member. A thickness of the integrated circuit board in a thickest area in the Z-axis direction in the conventional technology is a sum of a thickness of the printed circuit board, a thickness of the packaging member, and a thickness of an electrical component. The thickness of the printed circuit board is greater than the thickness of the flexible circuit board. Therefore, the thickness of the integrated circuit board provided in this application is reduced compared with that in the first conventional technology, which facilitates lightweight design of the electronic device.

In a second conventional technology, a thickness of another integrated circuit board is generally a sum of a thickness of a dot-shaped packaging member, a thickness of a reinforcing plate, and a thickness of an electrical component. In this application, the projection of the body part is completely located on the packaging member, that is, the packaging member is integrally formed on the body part, and the packaging member may play a supporting role. Therefore, a reinforcing plate does not need to be disposed. In this application, the thickness of the integrated circuit board is a sum of the thickness of the packaging member, the thickness of the flexible circuit board, and the thickness of the second electrical component. The thickness of the reinforcing plate is greater than the thickness of the flexible circuit board. Therefore, the thickness of the integrated circuit board provided in this application is reduced compared with that in the second conventional technology, thereby facilitating lightweight design of the electronic device.

In some embodiments, the packaging member is fastened to the body part in a molding manner. Therefore, the size of the packaging member is controllable, so that the packaging member is relatively small, and the size of the integrated circuit board is further reduced.

In some embodiments, there are at least two first electrical components, and the packaging member completely covers the at least two first electrical components.

In some embodiments, the body part has a first bearing surface, both the first electrical component and the packaging member are fastened to the first bearing surface, the packaging member includes a first package surface and a second package surface that are opposite in the thickness direction of the integrated circuit board, and the first package surface is fixedly connected to the first bearing surface; and in the at least two first electrical components, a first electrical component with the largest thickness includes an upper surface and a lower surface that are opposite in the thickness direction of the integrated circuit board, the lower surface is fixedly connected to the first bearing surface, and in the thickness direction of the integrated circuit board, a distance between the upper surface and the second package surface is greater than or equal to 0.05 mm and less than 0.3 mm.

In the conventional technology, when a component is disposed on a flexible board, each component is separately packaged in a glue dispensing manner, that is, each component is corresponding to one component used for packaging. A height difference between the component used for packaging and the component to be packaged is generally 0.3 mm. In this application, one packaging member is used to package all the first electrical components. A height difference between the packaging member and the first electrical component is less than 0.3 mm. The thickness dimension of the packaging member in this embodiment is reduced compared with that in the conventional technology, thereby contributing to a reduction in the thickness dimension of the integrated circuit board, and facilitating lightweight design of the electronic device.

In some embodiments, in the at least two first electrical components, a first electrical component with the largest width includes a front surface and a rear surface that are opposite in a width direction of the integrated circuit board; and the packaging member includes a first package side and a second package side that are opposite in the width direction of the integrated circuit board; and in the width direction of the integrated circuit board, a distance between the front surface and the first package side is greater than or equal to 0.1 mm and less than 0.6 mm; and a distance between the rear surface and the second package side is greater than or equal to 0.1 mm and less than 0.6 mm.

In the conventional technology, when a component is disposed on a flexible board, each component is separately packaged in a glue dispensing manner, that is, each component is corresponding to one component used for packaging. A spacing between the component used for packaging and an edge in the Y-axis direction of the component to be packaged is generally 0.6 mm. In this application, one packaging member is used to package all the first electrical components. A spacing between the packaging member and an edge in the Y-axis direction of the first electrical component is less than 0.6 mm. The width dimension of the packaging member in this embodiment is reduced compared with the conventional technology, thereby contributing to a reduced width dimension of the integrated circuit board, and facilitating lightweight design of the electronic device.

In some embodiments, the packaging member includes a first package end and a second package end that are opposite in a length direction of the integrated circuit board; and in the at least two first electrical components, the first electrical component closest to the first package end has a left side surface, and the first electrical component closest to the second package end has a right side surface; and in the length direction of the integrated circuit board, a distance between the left side surface and the first package end is greater than or equal to 0.1 mm and less than 0.6 mm; and a distance between the right side surface and the second package end is greater than or equal to 0.1 mm and less than 0.6 mm.

In the conventional technology, when a component is disposed on a flexible board, each component is separately packaged, that is, each component is corresponding to one component used for packaging. A spacing between the component used for packaging and an edge in the X-axis direction of the component to be packaged is generally 0.6 mm. In this application, one packaging member is used to package all the first electrical components. A spacing between the packaging member and an edge in the X-axis direction of the first electrical component is less than 0.6 mm. The length size of the packaging member in this embodiment is reduced compared with the conventional technology, thereby contributing to a reduced length size of the integrated circuit board, and facilitating lightweight design of the electronic device.

In some embodiments, the extension part includes a second bearing surface, and the second bearing surface and the first bearing surface are connected in the length direction of the integrated circuit board; and the packaging member includes a second package end, the second bearing surface is adjacent to the second package end, and there is an included angle between the second bearing surface and the second package end; and the integrated circuit board further includes an adhesive, one side of the adhesive is bonded to the second bearing surface, and the other side of the adhesive is bonded to the second package end.

In the process of preparing the packaging member, the liquid material may leak from the bottom of the mold to the second bearing surface of the extension part, and the leaked liquid material has an irregular shape, and may solidify to form a spike. After the integrated circuit board is applied to the electronic device, the extension part needs to bend relative to the packaging member and the body part. In this case, the spike formed by solidification of the liquid material may hurt the extension part. The adhesive is set to be of a regular shape, and does not produce a spike, thereby reducing a risk of being stabbed when the first extension part is bent.

In some embodiments, the extension part includes two extension sections that are connected at an angle, where an end of one of the extension sections is fixedly connected to the body part, and the connecting member and the reinforcing plate are disposed at an end of the other of the extension sections. The two extension sections are at an angle of 90 degrees, so that the extension section can be bent, so as to drive the connecting member to cooperate with another component.

In some embodiments, the extension part includes a first extension part and a second extension part, and the first extension part and the second extension part are respectively fastened on two sides of the body part that are opposite in the length direction of the integrated circuit board; and the reinforcing plate includes a first reinforcing plate and a second reinforcing plate, and the connecting member includes a first connecting member and a second connecting member. The first connecting member and the first reinforcing plate are respectively disposed on two sides of the first extension part that are opposite in the thickness direction of the integrated circuit board; and the second connecting member and the second reinforcing plate are respectively disposed on two sides of the second extension part that are opposite in the thickness direction of the integrated circuit board. In the thickness direction of the integrated circuit board, a projection of the first reinforcing plate on the first extension part and a projection of the first connecting member on the first extension part overlap at least partially; and a projection of the second reinforcing plate on the second extension part and a projection of the second connecting member on the second extension part overlap at least partially. Therefore, when the integrated circuit board is applied to a battery, it is convenient for the battery to arrange two conductive loops.

A second aspect of this application provides a battery module, including: a battery and the integrated circuit board in the first aspect of this application. The battery has a positive tab and a negative tab, the integrated circuit board is disposed at an end of the battery, the positive tab and the negative tab are fixedly connected to the second electrical component, the positive tab and the negative tab are electrically connected to the second electrical component, the second electrical component is electrically connected to the first electrical component, and the first electrical component is electrically connected to the connecting member. A size of an integrated circuit board is smaller than that in the conventional technology. Therefore, a size of the battery module is smaller than that in the conventional technology. After the battery module is installed in an electronic device, occupied space is smaller, which facilitates lightweight design of the electronic device.

A third aspect of this application provides an electronic device, including a housing, a main circuit board, and the battery module in the second aspect of this application. Both the main circuit board and the battery module are disposed inside the housing; a plug connector is disposed on the main circuit board, and the connecting piece and the plug connector are connected to each other, so that the positive tab, the integrated circuit board, the main circuit board, and the negative tab form a conductive loop. A size of an integrated circuit board is smaller than that in the conventional technology. Therefore, a size of the battery module is smaller than that in the conventional technology. After the battery module is installed in an electronic device, occupied space is smaller, which facilitates lightweight design of the electronic device.

A fourth aspect of this application provides an integrated circuit board preparation method, including: providing a flexible substrate, where the flexible substrate includes the flexible circuit board; fastening an auxiliary reinforcing plate to the body part, so that a projection of the body part is completely located on the auxiliary reinforcing plate in a thickness direction of the integrated circuit board; fastening the first electrical component to the body part, and fastening the connecting member to an extension part; fastening the packaging member to the body part, so that the packaging member completely covers the first electrical component; peeling the auxiliary reinforcing plate off from the body part; and fastening the second electrical component to the body part.

According to the integrated circuit board preparation method provided in this application, the packaging member is directly fastened to the flexible circuit board, and a printed circuit board does not need to be disposed. The thickness of the integrated circuit board is smaller than that in the conventional technology. In addition, the length, the width, and the thickness of the packaging member are reduced compared with those in the conventional technology, so that an overall size of the integrated circuit board prepared is relatively small. When the integrated circuit board is applied to an electronic device, occupied space is relatively small, which facilitates lightweight design of the electronic device.

In addition, when the first electrical component is fastened to the body part, the auxiliary reinforcing plate is fastened to the flexible circuit board. In this case, the auxiliary reinforcing plate serves to support the body part of the flexible circuit board, so as to ensure that the body part remains in a flat state, avoid a dead broken line in the body part, and reduce a risk of welding failure of the first electrical component. When the second electrical component is welded to the second pad, the auxiliary reinforcing plate is peeled off, and the packaging member serves to support the body part, to facilitate welding of the second electrical component, and reduce a risk of a welding failure of the second electrical component.

In some embodiments, the fastening the packaging member to the body part specifically includes: placing a mold on the flexible substrate, to enable a side that is of the body part and on which the first electrical component is disposed to be located inside the mold; and placing a raw material in the mold, heating the raw material, to enable the raw material to become a liquid material, and cooling the liquid material to form the packaging member. That is, the packaging member is fastened to the body part in a molding manner, so that a shape and a size of the packaging member are controllable. Therefore, the packaging member can be completely coated with the first electrical component, and the size of the packaging member can be reduced, so as to reduce the size of the integrated circuit board.

In some embodiments, the flexible substrate further includes a redundant plate, and the redundant plate is formed integrally with the flexible circuit board; and the fastening an auxiliary reinforcing plate to the body part specifically includes: bonding the auxiliary reinforcing plate to the redundant plate by using an adhesive. In this way, the auxiliary reinforcing plate can be made into the body part, and the adhesive can be prevented from damaging a pad used by the body part to connect an electrical component.

In some embodiments, the flexible substrate includes a plurality of flexible circuit boards. After the second electrical component is fastened to the body part, the integrated circuit board preparation method further includes: cutting the flexible substrate, and after the redundant plate is removed, forming a plurality of integrated circuit boards.

A fifth aspect of this application provides an integrated circuit board, including a flexible circuit board, a first electrical component, and a packaging member; where the first electrical component is disposed on a surface of a side of the flexible circuit board; the packaging member is fastened to the flexible circuit board, and the packaging member completely covers the first electrical component; and in a thickness direction of the integrated circuit board, a projection of the flexible circuit board is completely located on the packaging member.

In this application, a thickness of a thickest area of the integrated circuit board in a Z-axis direction is a sum of a thickness of the packaging member and a thickness of the flexible circuit board. In the first conventional technology, the integrated circuit board generally includes a printed circuit board, a flexible circuit board, and a packaging member. A thickness of the integrated circuit board in a thickest area in the Z-axis direction in the conventional technology is a sum of a thickness of the printed circuit board and a thickness of the packaging member. The thickness of the printed circuit board is greater than the thickness of the flexible circuit board. Therefore, the thickness of the integrated circuit board provided in this application is reduced compared with that in the first conventional technology, which facilitates lightweight design of the electronic device.

In the second conventional technology, a thickness of another integrated circuit board is generally a sum of a thickness of a dot-shaped packaging member and a thickness of a reinforcing plate. In this application, the projection of the body part is completely located on the packaging member, that is, the packaging member is integrally formed on the body part, and the packaging member may play a supporting role. Therefore, no reinforcing board needs to be disposed. In this application, the thickness of the integrated circuit board is a sum of a thickness of the packaging member and a thickness of the flexible circuit board. The thickness of the reinforcing plate is greater than the thickness of the flexible circuit board. Therefore, the thickness of the integrated circuit board provided in this application is reduced compared with that in the second conventional technology, thereby facilitating lightweight design of the electronic device.

In some embodiments, the packaging member is fastened to the flexible circuit board in a molding manner.

In some embodiments, there are at least two first electrical components, and the packaging member completely covers the at least two first electrical components.

In some embodiments, the flexible circuit board has a first surface; both the first electrical component and the packaging member are fastened to the first surface; and the packaging member includes a first package surface and a second package surface that are opposite in the thickness direction of the integrated circuit board, and the first package surface is fixedly connected to the first surface; and in the at least two first electrical components, a first electrical component with the largest thickness includes an upper surface and a lower surface that are opposite in the thickness direction of the integrated circuit board, the lower surface is fixedly connected to the first surface, and in the thickness direction of the integrated circuit board, a distance between the upper surface and the second package surface is greater than or equal to 0.05 mm and less than 0.3 mm.

In some embodiments, in the at least two first electrical components, a first electrical component with the largest width includes a front surface and a rear surface that are opposite in a width direction of the integrated circuit board; and the packaging member includes a first package side and a second package side that are opposite in the width direction of the integrated circuit board; and in the width direction of the integrated circuit board, a distance between the front surface and the first package side is greater than or equal to 0.1 mm and less than 0.6 mm; and a distance between the rear surface and the second package side is greater than or equal to 0.1 mm and less than 0.6 mm.

In some embodiments, the packaging member includes a first package end and a second package end that are opposite in a length direction of the integrated circuit board; and in the at least two first electrical components, the first electrical component closest to the first package end has a left side surface, and the first electrical component closest to the second package end has a right side surface; and in the length direction of the integrated circuit board, a distance between the left side surface and the first package end is greater than or equal to 0.1 mm and less than 0.6 mm; and a distance between the right side surface and the second package end is greater than or equal to 0.1 mm and less than 0.6 mm.

In some embodiments, the integrated circuit board further includes a second electrical component, and the second electrical component is fastened to a surface of a side of the flexible circuit board that is away from the first electrical component.

A sixth aspect of this application provides an integrated circuit board preparation method, including: providing a flexible substrate, where the flexible substrate includes the flexible circuit board; fastening an auxiliary reinforcing plate to the flexible circuit board, so that a projection of the flexible circuit board is completely located on the auxiliary reinforcing plate in a thickness direction of the integrated circuit board; fastening the first electrical component to the flexible circuit board; fastening the packaging member to the flexible printed circuit, so that the packaging member completely covers the first electrical component; and peeling the auxiliary reinforcing plate off from the flexible circuit board.

According to the integrated circuit board preparation method provided in this application, the packaging member is directly fastened to the flexible circuit board, and a printed circuit board does not need to be disposed. The thickness of the integrated circuit board is smaller than that in the conventional technology. In addition, the length, the width, and the thickness of the packaging member are reduced compared with those in the conventional technology, so that an overall size of the integrated circuit board prepared is relatively small. When the integrated circuit board is applied to an electronic device, occupied space is relatively small, which facilitates lightweight design of the electronic device.

In addition, when the first electrical component is fastened to the flexible circuit board, the auxiliary reinforcing plate is fastened to the flexible circuit board. In this case, the auxiliary reinforcing plate serves to support the flexible circuit board, so as to ensure that the flexible circuit board is in a flat state, avoid a dead broken line of the flexible circuit board, and reduce a risk of a welding failure of the first electrical component. The auxiliary reinforcing plate is then peeled off to reduce the thickness of the integrated circuit board.

In some embodiments, the fastening the packaging member to the flexible circuit board specifically includes: placing a mold on the flexible substrate, to enable a side that is of the flexible circuit board and on which the first electrical component is disposed to be located inside the mold; and placing a raw material in the mold, heating the raw material, to enable the raw material to become a liquid material, and cooling the liquid material to form the packaging member.

In some embodiments, the flexible substrate further includes a redundant plate, and the redundant plate is formed integrally with the flexible circuit board; and the fastening an auxiliary reinforcing plate to the body part specifically includes: bonding the auxiliary reinforcing plate to the redundant plate by using an adhesive.

In some embodiments, after the peeling the auxiliary reinforcing plate off from the flexible circuit board, the integrated circuit board preparation method further includes: fastening a second electrical component to a surface of a side of the flexible circuit board that is away from the first electrical component; the flexible substrate includes a plurality of flexible circuit boards; and after the second electrical component is fastened to the flexible circuit board, the integrated circuit board preparation method further includes: cutting the flexible substrate, and removing the redundant plate to form a plurality of integrated circuit boards.

### BRIEF DESCRIPTION OF DRAWINGS

To describe technical solutions in embodiments or the background of this application more clearly, the following describes accompanying drawings required in the embodiments or the background of this application.
FIG. 1 is a schematic diagram of a structure of a mobile phone according to an embodiment of this application;
FIG. 2 is a schematic diagram of an exploded structure of the mobile phone shown in FIG. 1;
FIG. 3 is a schematic diagram of an exploded structure of a battery module of the mobile phone shown in FIG. 2;
FIG. 4 is a schematic diagram of a structure of an integrated circuit board of the battery module shown in FIG. 3;
FIG. 5 is a schematic diagram of an exploded structure of a partial structure of the integrated circuit board shown in FIG. 4;
FIG. 6 is a schematic diagram of a structure of the integrated circuit board shown in FIG. 4 in another direction;
FIG. 7 is a schematic enlarged diagram of A in FIG. 4;
FIG. 8 is a schematic enlarged view of C in FIG. 6;
FIG. 9 is a schematic enlarged view of B in FIG. 4;
FIG. 10 is a schematic enlarged diagram of D in FIG. 6;
FIG. 11 is a schematic diagram of a process of an integrated circuit board preparation method according to a second embodiment of this application;
FIG. 12 is a schematic diagram of step S13 in FIG. 11 in another direction;
FIG. 13 is a schematic diagram of simultaneously processing a plurality of integrated circuit boards according to the integrated circuit board preparation method provided in the second embodiment of this application;
FIG. 14 is a schematic diagram of an exploded structure of a mobile phone according to a third embodiment of this application;
FIG. 15 is a schematic diagram of an exploded structure of a battery module of the mobile phone shown in FIG. 14;
FIG. 16 is a schematic diagram of a structure of an integrated circuit board of the battery module shown in FIG. 14;
FIG. 17 is a schematic diagram of an exploded structure of a partial structure of the integrated circuit board shown in FIG. 16;
FIG. 18 is a schematic diagram of a structure of the integrated circuit board shown in FIG. 16 in another direction;
FIG. 19 is a schematic diagram of a process of an integrated circuit board preparation method according to a fourth embodiment of this application;
FIG. 20 is a schematic diagram of a structure of an integrated circuit board according to a fifth embodiment of this application;
FIG. 21 is a schematic diagram of a process of an integrated circuit board preparation method according to a sixth embodiment of this application;
FIG. 22 is a schematic diagram of a structure of an integrated circuit board according to a seventh embodiment of this application;
FIG. 23 is a schematic diagram of a process of an integrated circuit board preparation method according to an eighth embodiment of this application; and
FIG. 24 is a schematic diagram of a structure of a wearable device according to a ninth embodiment of this application.

### DESCRIPTION OF EMBODIMENTS

The following describes embodiments of this application with reference to accompanying drawings in the embodiments of this application.

This application provides an electronic device. The electronic device includes but is not limited to a mobile phone (cellphone), a notebook computer (notebook computer), a tablet personal computer (tablet personal computer), a personal digital assistant (personal digital assistant), a wearable device (wearable device), or a mobile device (mobile device).

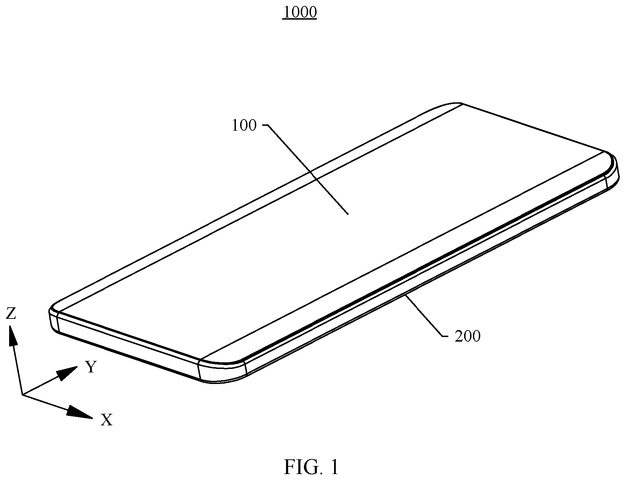

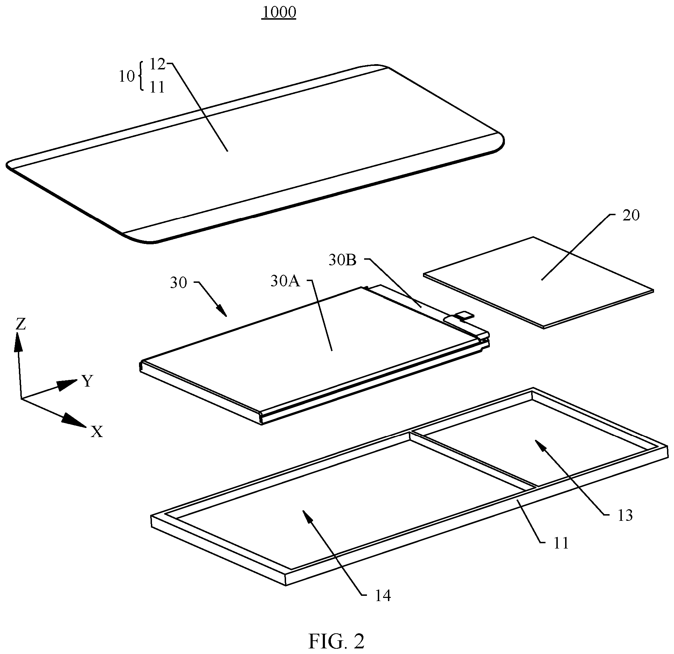

Refer to FIG. 1 and FIG. 2. FIG. 1 is a schematic diagram of a structure of a mobile phone according to a first embodiment of this application. FIG. 2 is a schematic diagram of an exploded structure of the mobile phone shown in FIG. 1.

In the first embodiment of this application, an example in which the electronic device is a mobile phone 1000 is used for description. For ease of description, a width direction of the mobile phone 1000 is defined as an X-axis direction, a length direction of the mobile phone 1000 is defined as a Y-axis direction, and a thickness direction of the mobile phone 1000 is defined as a Z-axis direction. Every two of the X-axis direction, the Y-axis direction, and the Z-axis direction are perpendicular to each other.

It should be noted that the orientation words such as "top", "bottom", "left", "right", "front", and "back" used in embodiments of this application to describe the mobile phone 1000 are mainly explained based on display orientations of the mobile phone 1000 in FIG. 1 and FIG. 2, with "top" or "upper" facing a positive direction of the Z-axis, "bottom" or "lower" facing a negative direction of the Z-axis, "right" facing a positive direction of the X-axis, "left" facing a negative direction of the X-axis, "back" facing a positive direction of the Y-axis, and "front" facing a negative direction of the Y-axis. This does not limit the orientation of the mobile phone 1000 in an actual application scenario.

The mobile phone 1000 may have one conductive loop, two conductive loops, or the like. Correspondingly, one positive tab, two positive tabs, or the like are required to be disposed on a battery of the mobile phone 1000; an extension part, two extension parts, or the like are correspondingly required on an integrated circuit board used to protect the battery, and a connecting member is disposed corresponding to each extension part. The connecting member may be a male end of a board-to-board connector, or the like. In an embodiment of this application, that one positive tab and one negative tab are disposed on a battery is used as an example. The positive tab is referred to as a first positive tab. One first connecting member is disposed on a corresponding integrated circuit board. In another embodiment of this application, that two positive tabs and one negative tab are disposed on a battery is used as an example. The two positive tabs are a first positive tab and a second positive tab, and a first extension part and a second extension part are disposed on a corresponding integrated circuit board. A first connecting member is disposed on the first extension part, and a second connecting member is disposed on the second extension part. The following details are given.

In the first embodiment of this application, the mobile phone 1000 includes a body 100 and a display screen 200.

In the first embodiment of this application, the display screen 200 has a touch function, and is configured to operate the mobile phone 1000 and display information such as an image and a video. The display screen 200 includes a display surface and a mounting surface, the display screen 200 is mounted on the body 100, the mounting surface of the display screen 200 faces the body 100, and the display surface of the display screen 200 faces away from the body 100.

In the first embodiment of this application, the display screen 200 may be an organic light-emitting diode (organic light-emitting diode, OLED) display 200, an active-matrix organic light-emitting diode (active-matrix organic light-emitting diode, AMOLED) display 200, a mini light-emitting diode (mini organic lightemitting diode) display 200, a micro light-emitting diode (micro organic light-emitting diode) display 200, a micro organic light-emitting diode (micro organic light-emitting diode) display 200, or a quantum dot light-emitting diode (uantum dot light emitting diodes, QLED) display 200.

In the first embodiment of this application, the body 100 includes a housing 10, a main circuit board 20, and a battery module 30. Both the main circuit board 20 and the battery module 30 are installed in the housing 10. The main circuit board 20 is integrated with components such as a first power management chip (not shown in the figure), a central processing unit (not shown in the figure), and a first plug connector (not shown in the figure). The first plug connector is a female end of a board to board (board to board, BTB) connector, and the first plug connector is configured to connect to the battery module 30, so as to implement electrical connection between the main circuit board 20 and the battery module 30. The first power management chip is configured to manage information such as an electricity quantity of a battery 30A, a charging status, and brightness of the display screen 200. The central processing unit is configured to read and execute an instruction, to enable the mobile phone 1000 to perform functions such as communication, text browsing, and video browsing.

The battery module 30 includes the battery 30A and an integrated circuit board 30B. The integrated circuit board 30B is configured to protect the battery 30A. Specifically, the integrated circuit board 30B is configured to detect a current and a voltage of the battery module 30, and disconnect a conductive loop of the battery 30A when the current exceeds a threshold or the voltage exceeds a threshold, thereby protecting the battery 30A. The battery 30A, the integrated circuit board 30B, and the first power management chip are electrically connected in sequence, and the battery 30A supplies power to components such as the central processing unit (not shown in the figure) and the display screen 200 through the integrated circuit board 30B and the first power management chip.

The housing 10 includes a middle frame 11 and a rear cover 12. The middle frame 11 includes a middle plate and a side frame, the side frame surrounds the middle plate and is connected to the middle plate, and the middle plate and the side frame enclose an accommodating cavity. The accommodating cavity is configured to install components such as the main circuit board 20 and the battery module 30. The rear cover 12 is fixed on a side of the side frame in the Z-axis direction, and the rear cover 12 closes the accommodating cavity. The display screen 200 is mounted on a side that is of the middle frame 11 and that is away from the rear cover 12. Specifically, the accommodating cavity includes a circuit compartment 13 and a battery compartment 14. The circuit compartment 13 and the battery compartment 14 are arranged in sequence in the Y-axis direction. The circuit compartment 13 is configured to install the main circuit board 20, and the battery compartment 14 is configured to install the battery module 30.

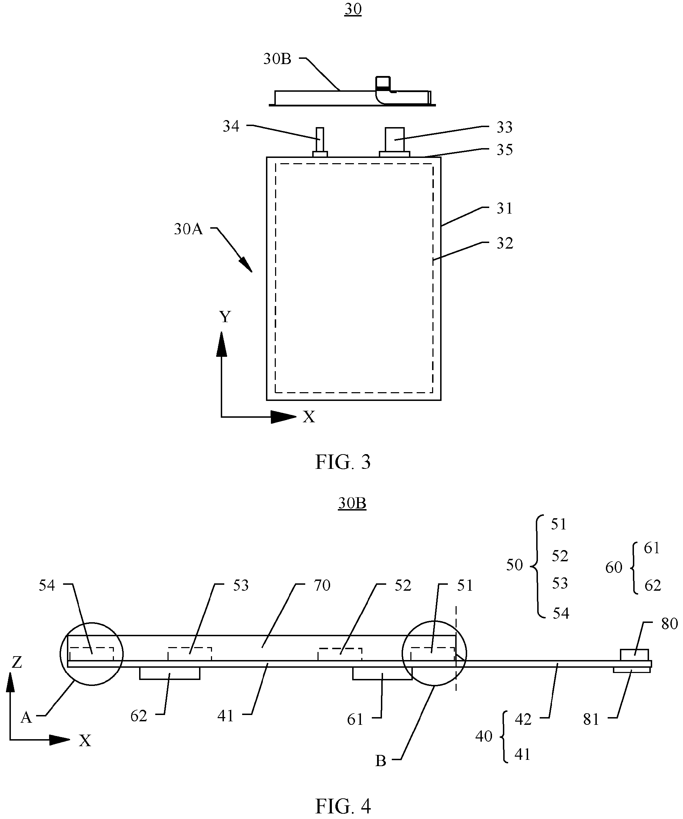

FIG. 3 is a schematic diagram of an exploded structure of the battery module of the mobile phone shown in FIG. 2.

The battery 30A of the battery module 30 includes an enclosure 31, a bare cell 32, and a wrapping film (not shown in the figure). The enclosure 31 is in a rectangular shape, and the enclosure 31 has a first encircling wall 35 on a side in the Y-axis direction. The wrapping film is wrapped around an outer side of the enclosure 31.

The bare cell 32 includes first electrode plates (not shown in the figure) and second electrode plates (not shown in the figure) that are alternately laminated in the Z-axis direction, an isolation film is disposed between adjacent first electrode plate and second electrode plate, and the isolation film is used to insulate the first electrode plate and the second electrode plate. The first electrode plate has a first positive tab 33, and the second electrode plate has a negative tab 34. In another embodiment, the first electrode plate, the second electrode plate, and the isolation film may be wound into the bare cell 32.

The bare cell 32 is installed in a receiving cavity of the enclosure 31, and both the first positive tab 33 and the negative tab 34 protrude from the first encircling wall 35, and electrolyte is filled in the receiving cavity.

FIG. 4 is a schematic diagram of a structure of the integrated circuit board of the battery module shown in FIG. 3.

The integrated circuit board 30B of the battery module 30 includes a flexible printed circuit (flexible printed circuit, FPC) board 40, a first electrical component 50, a second electrical component 60, a packaging member 70, a first connecting member 80, and a first reinforcing plate 81. It may be understood that the integrated circuit board 30B is in a strip shape and extends in the X-axis direction. Therefore, the X-axis direction is a length direction of the integrated circuit board 30B, and the X-axis direction is a width direction of the integrated circuit board 30B. The first electrical component 50, the second electrical component 60, and the first connecting member 80 are all integrated on the flexible circuit board 40, and the packaging member 70 is configured to package the first electrical component 50.

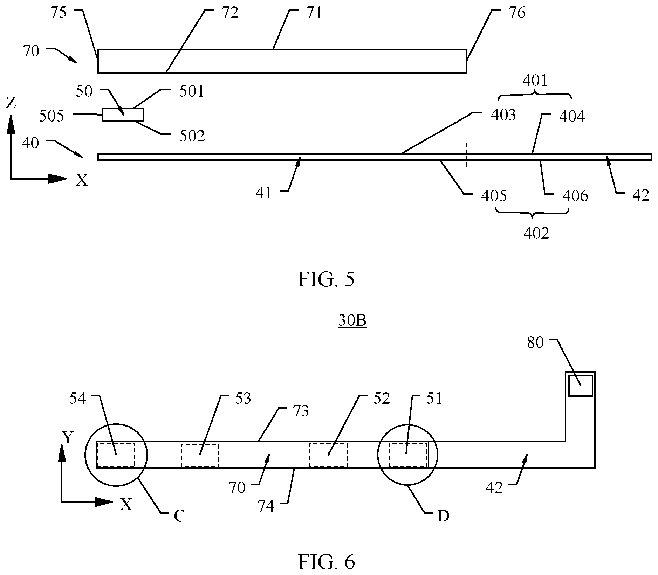

FIG. 5 is a schematic diagram of an exploded structure of a partial structure of the integrated circuit board shown in FIG. 4.

The flexible circuit board 40 is rectangular in shape, and the flexible circuit board 40 has a first surface 401 and a second surface 402 that are opposite to each other in the Z-axis direction. The first surface 401 includes a first bearing surface 403 and a second bearing surface 404 that are connected in sequence along the X-axis direction, and the second surface 402 includes a third bearing surface 405 and a fourth bearing surface 406 that are connected in sequence along the X-axis direction.

Refer to FIG. 5 and FIG. 6 together. FIG. 6 is a schematic diagram of a structure of the integrated circuit board shown in FIG. 4 in another direction.

The flexible circuit board 40 includes a body part 41 and a first extension part 42 that are sequentially connected in the X-axis direction. The first bearing surface 403 and the third bearing surface 405 are located on two sides of the body part 41 that are opposite to each other in the Z-axis direction, and the second bearing surface 404 and the fourth bearing surface 406 are located on two sides of the first extension part 42 that are opposite to each other in the Z-axis direction. The first extension part 42 includes a first extension section and a second extension section, and the first extension section and the second extension section are connected at an angle. Specifically, the first extension section and the second extension section may be connected at 90 degrees. An end of the first extension section that is away from the second extension section is connected to the body part 41.

Refer to FIG. 4. The first electrical component 50 is an electronic component integrated on the first bearing surface 403, and the second electrical component 60 is an electronic component integrated on the third bearing surface 405. The first electrical component 50 includes a first current detection element 51 and a first protection unit. A quantity of first protection units may be one or two. The first protection unit includes a first detection chip 52 and a first switch element 53. The first current detection element 51 is a resistor, and the first switch element 53 is a P-type or N-type metal-oxide-semiconductor (metal-oxide-semiconductor, MOS) field-effect transistor. The plurality of first electrical components 50 may be electrically connected to each other by using a copper foil line layer on the body part 41, and the first electrical component 50 does not need to be in contact with another external component. The first electrical component 50 may further include an anti-counterfeit chip 54, and the anti-counterfeit chip 54 is configured to identify whether the battery module 30 is a genuine product.

Refer to FIG. 4. The second electrical component 60 includes a first positive electrode connecting member 61 and a negative electrode connecting member 62, and both the first positive electrode connecting member 61 and the negative electrode connecting member 62 are nickel pieces. The first positive electrode connecting member 61 is configured to be fixedly connected to the first positive tab 33 of the battery 30A, and the negative electrode connecting member 62 is configured to be fixedly connected to the negative tab 34 of the battery 30A. Therefore, both the first positive electrode connecting member 61 and the negative electrode connecting member 62 need to be exposed.

Refer to FIG. 4 and FIG. 5. The packaging member 70 is a hard member made of an insulating material such as epoxy resin. The packaging member 70 is stacked on the first bearing surface 403 of the body part 41 of the flexible circuit board 40, and the packaging member 70 covers the first electrical component 50. Because the first electrical component 50 does not need to be in contact with another external component, the first electrical component 50 may be protected by using the packaging member 70 to cover the first electrical component 50. In the Z-axis direction, the projection of the body part 41 is completely located on the packaging member 70. That is, the packaging member 70 as a whole covers the body part 41, so as to support the body part 41.

Refer to FIG. 5. The packaging member 70 has a first package surface 71 and a second package surface 72 that are opposite to each other in the Z-axis direction, has a first package side 73 and a second package side 74 that are opposite to each other in the Y-axis direction, and a first package end 75 and a second package end 76 that are opposite to each other in the X-axis direction.

The first package surface 71 of the packaging member 70 is directly fastened to the first bearing surface 403 of the flexible circuit board 40, so that the packaging member 70 can support the body part 41. That the packaging member 70 covers the first electrical component 50 may be understood as: The first electrical component 50 extends from the first package surface 71 into the interior of the packaging member 70, and there is no gap between the first electrical component 50 and the packaging member 70, that is, the first electrical component 50 is embedded into the packaging member 70. More specifically, in a thickness direction of the integrated circuit board 30B, a thickness dimension of the packaging member 70 is greater than a thickness dimension of the first electrical component 50. In a width direction of the integrated circuit board 30B, a width dimension of the packaging member 70 is greater than a width dimension of the first electrical component 50. In a length direction of the integrated circuit board 30B, a distance from a left side surface 505 of the leftmost first electrical component 50 to a right side surface 506 of the rightmost first electrical component 50 is less than a length size of the packaging member 70. That is, the packaging member 70 may further function to protect the first electrical component 50.

In the first embodiment of this application, the packaging member 70 is fastened to the body part 41 in a molding manner. Therefore, the size of the packaging member 70 is controllable, so that the packaging member 70 is relatively small, and the size of the integrated circuit board is reduced. In addition, there are a plurality of first electrical components 50, and a first current detection element 51, a first detection chip 52, and a first switch element 53 are specifically included. Compared with the conventional technology in which each first electrical component is separately packaged on a flexible circuit board in a dot-like manner, molded packaging allows for simultaneously packaging all the first electrical components 50 into one package, which has relatively low packaging difficulty and can improve packaging efficiency.

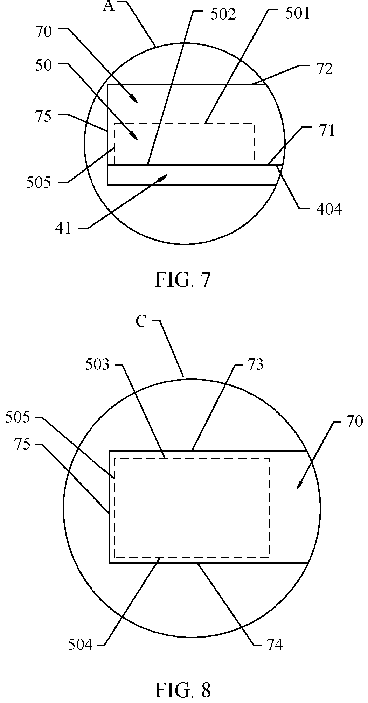

Refer to FIG. 5 and FIG. 7. FIG. 7 is a schematic enlarged diagram of A in FIG. 4. In the plurality of first electrical components 50, the first electrical component 50 with the largest thickness includes an upper surface 501 and a lower surface 502 that are opposite to each other in the Z-axis direction. The lower surface 502 is fixedly connected to the first bearing surface 403. In the Z-axis direction, a distance between the upper surface 501 and the first bearing surface 403 is less than a distance between the second package surface 72 and the first bearing surface 403. In this way, the packaging member 70 completely covers all the first electrical components 50 in the Z-axis direction.

Further, after molding, the shape of the packaging member 70 is controllable. Therefore, the size of the packaging member 70 is smaller than that in the conventional technology. Specifically, in the Z-axis direction, a distance between the upper surface 501 and the second package surface 72 is greater than or equal to 0.05 mm, and is less than 0.3 mm. The distance between the upper surface 501 and the second package surface 72 may be specifically 0.05 mm, 0.06 mm, 0.07 mm, 0.08 mm, 0.09 mm, 0.1 mm, 0.12 mm, 0.13 mm, 0.15 mm, 0.18 mm, 0.21 mm, 0.25 mm, 0.28 mm, 0.29 mm, or the like. In the conventional technology, when a component is disposed on a flexible board, each component is separately packaged, that is, each component is corresponding to one component used for packaging. A height difference between the component used for packaging and the component to be packaged is generally 0.3 mm. In this application, one packaging member 70 is used to package all the first electrical components 50. A height difference between the packaging member 70 and the first electrical component 50 is less than 0.3 mm. The thickness dimension of the packaging member 70 in the first embodiment of this application is reduced compared with that in the conventional technology, thereby contributing to a reduction in the thickness dimension of the integrated circuit board 30B, and facilitating lightweight design of the electronic device.

For the plurality of first electrical components 50, refer to FIG. 6 and FIG. 8. FIG. 8 is a schematic enlarged diagram of C in FIG. 6. The first electrical component 50 with the largest width includes a front surface 503 and a rear surface 504 that are opposite to each other in the Y-axis direction. The packaging member 70 includes a first package side 73 and a second package side 74 that are opposite to each other in the width direction of the integrated circuit board 30B. In the Y-axis direction, a distance between the front surface 503 and the first package side 73 is greater than or equal to 0.1 mm, and is less than 0.6 mm. The distance between the front surface 503 and the first package side 73 may be specifically 0.1 mm, 0.12 mm, 0.15 mm, 0.18 mm, 0.21 mm, 0.24 mm, 0.27 mm, 0.3 mm, 0.35 mm, 0.4 mm, 0.45 mm, 0.48 mm, 0.51 mm, 0.53 mm, 0.55 mm, 0.57 mm, 0.59 mm, or the like. A distance between the rear surface 504 and the second package side 74 is greater than or equal to 0.1 mm and less than 0.6 mm. The distance between the rear surface 504 and the second package side 74 may be specifically 0.1 mm, 0.11 mm, 0.14 mm, 0.17 mm, 0.2 mm, 0.23 mm, 0.26 mm, 0.3 mm, 0.37 mm, 0.4 mm, 0.44 mm, 0.49 mm, 0.5 mm, 0.52 mm, 0.55 mm, 0.57 mm, 0.59 mm, or the like.

In this way, the packaging member 70 completely covers all the first electrical components 50 in the Y-axis direction. In addition, in the conventional technology, when a component is disposed on a flexible board, each component is separately packaged, that is, each component is corresponding to one component used for packaging. A spacing between the component used for packaging and an edge in the Y-axis direction of the component to be packaged is generally 0.6 mm. In this application, one packaging member 70 is used to package all the first electrical components 50. A spacing between the packaging member 70 and an edge in the Y-axis direction of the first electrical component 50 is less than 0.6 mm. The width dimension of the packaging member 70 in the first embodiment of this application is reduced compared with the conventional technology, thereby contributing to a reduced width dimension of the integrated circuit board 30B, and facilitating lightweight design of the electronic device.

Refer to FIG. 7 and FIG. 8, in the plurality of first electrical components 50, the first electrical component 50 closest to the first package end 75 has a left side surface 505. The packaging member 70 includes a first package end 75 and a second package end 76 that are opposite to each other in the X-axis direction. In the X-axis direction, a distance between the left side surface 505 and the first package end 75 is greater than or equal to 0.1 mm and less than 0.6 mm. The distance between the left side surface 505 and the first package end 75 may be specifically 0.1 mm, 0.13 mm, 0.16 mm, 0.19 mm, 0.2 mm, 0.23 mm, 0.27 mm, 0.3 mm, 0.34 mm, 0.42 mm, 0.45 mm, 0.48 mm, 0.5 mm, 0.52 mm, 0.54 mm, 0.56 mm, 0.58 mm, or the like.

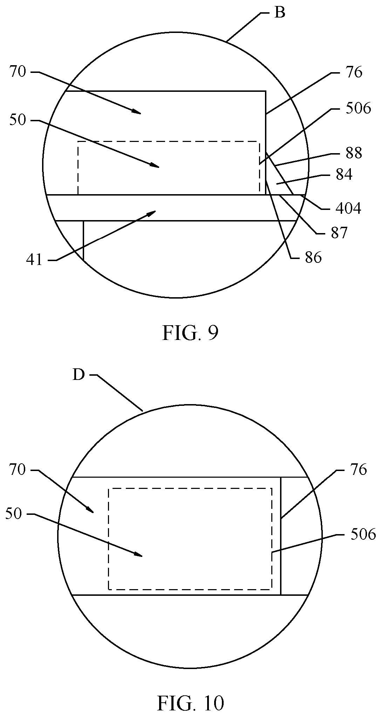

Refer to FIG. 9 and FIG. 10. FIG. 9 is a schematic enlarged diagram of B in FIG. 4, and FIG. 10 is a schematic enlarged diagram of D in FIG. 6. The first electrical component 50 closest to the second package end 76 has a right side surface 506, and a distance between the right side surface 506 and the second package end 76 is greater than or equal to 0.1 mm and less than 0.6 mm. The distance between the right side surface 506 and the second package end 76 may be specifically 0.1 mm, 0.13 mm, 0.16 mm, 0.19 mm, 0.2 mm, 0.25 mm, 0.28 mm, 0.3 mm, 0.34 mm, 0.42 mm, 0.45 mm, 0.48 mm, 0.5 mm, 0.52 mm, 0.54 mm, 0.56 mm, 0.58 mm, or the like.

In this way, the packaging member 70 completely covers all the first electrical components 50 in the X-axis direction. In addition, in the conventional technology, when a component is disposed on a flexible board, each component is separately packaged, that is, each component is corresponding to one component used for packaging. A spacing between the component used for packaging and an edge in the X-axis direction of the component to be packaged is generally 0.6 mm. In this application, one packaging member 70 is used to package all the first electrical components 50. A spacing between the packaging member 70 and an edge in the X-axis direction of the first electrical component 50 is less than 0.6 mm. The length size of the packaging member 70 in the first embodiment of this application is reduced compared with the conventional technology, thereby contributing to a reduced length size of the integrated circuit board 30B, and facilitating lightweight design of the electronic device.

After the packaging member 70 is packaged on the body part 41, the body part 41 and the packaging member 70 form an integral structure, so as to support the body part 41 to protect the first electrical component 50. In addition, the projection of the second electrical component 60 in the Z-axis direction is completely located on the packaging member 70, that is, the packaging member 70 further supports the second electrical component 60. In this case, the first extension part 42 keeps in a flexible state, and the first extension part 42 may bend relative to the packaging member 70 and the body part 41.

In the first embodiment of this application, as shown in FIG. 4, FIG. 5, and FIG. 9, a first adhesive 84 is disposed between the second package end 76 of the packaging member 70 and the second bearing surface 404 of the first extension part 42, and a cross-sectional shape of the first adhesive 84 is a triangle. The first adhesive 84 has a first adhesive surface 86, a second adhesive surface 87, and a first connection surface 88, and the first adhesive surface 86, the second adhesive surface 87, and the first connection surface 88 are successively connected end to end. The first adhesive surface 86 is bonded to the packaging member 70, and the second adhesive surface 87 is bonded to the first extension part 42.

Generally, the packaging member 70 is prepared in a molding manner on the body part 41, that is, the body part 41 is placed in a mold, and then a raw material is placed in the mold, and the raw material is heated, so that the raw material becomes a liquid material, and the liquid material can become the packaging member 70 after being cooled. Here, the raw material is a granular material in which epoxy resin and a curing agent are integrated.

After the foregoing liquid material is injected into the mold, the liquid material may leak from the bottom of the mold to the second bearing surface 404 of the first extension part 42, and a shape of the leaked liquid material is irregular, and may solidify to form a spike. After the integrated circuit board 30B is applied to the electronic device, the first extension part 42 needs to bend relative to the packaging member 70 and the body part 41. In this case, the spike formed by solidification of the liquid material may hurt the first extension part 42. In the first embodiment of this application, the first adhesive 84 is disposed between the packaging member 70 and the first extension part 42, and the first adhesive 84 has a regular shape, and does not generate a spike, thereby reducing a risk of being stabbed when the first extension part 42 is bent.

In the first embodiment of this application, the first connecting member 80 is integrated on the second bearing surface 404 of the flexible circuit board 40, and the first reinforcing plate 81 is fastened to the fourth bearing surface 406. More specifically, the first connecting member 80 is integrated at an end of the second extension section that is away from the first extension section, and the first reinforcing plate 81 is configured to support a counter-plug. The first connecting member 80 is a male end of a board-to-board connector. The first connecting member 80 is configured to interconnect with a first plug connector disposed on the main circuit board 20, and the first plug connector is a female end of the board-to-board connector. The first extension part 42 is bendable, and the first extension part 42 may be bent relative to the packaging member 70 and the body part 41, so that the first connecting member 80 on the first extension part 42 can be plugged into the first plug connector on the main circuit board 20. In another embodiment, the first connecting member 80 is integrated on the fourth bearing surface 406 of the flexible circuit board 40, and the first reinforcing plate 81 is fastened to the second bearing surface 404.

In the first embodiment of this application, a thickness of the thickest area of the integrated circuit board 30B in the Z-axis direction is a sum of a thickness dimension of the packaging member 70, a thickness dimension of the flexible circuit board 40, and a thickness dimension of the second electrical component 60. In a first conventional technology, the integrated circuit board 30B generally includes a printed circuit board (printed circuit boards, PCB), a flexible circuit board 40, and a packaging member 70. A thickness of the integrated circuit board 30B in a thickest area in the Z-axis direction in the first conventional technology is a sum of a thickness of the printed circuit board, a thickness of the packaging member 70, and a thickness of an electrical component. The thickness of the printed circuit board is greater than the thickness of the flexible circuit board 40. Therefore, the thickness of the integrated circuit board 30B provided in this embodiment is reduced compared with that in the first conventional technology, which facilitates lightweight design of the electronic device.

In a second conventional technology, a thickness of another integrated circuit board is generally a sum of a thickness of a dot-shaped packaging member, a thickness of a reinforcing plate, and a thickness of an electrical component. In this application, the projection of the body part 41 is completely located on the packaging member 70, that is, the packaging member 70 is integrally formed on the body part, and the packaging member 70 may play a supporting role. Therefore, a reinforcing plate does not need to be disposed. In this application, the thickness of the integrated circuit board is a sum of the thickness of the packaging member 70, the thickness of the flexible circuit board 40, and the thickness of the second electrical component 60. The thickness of the reinforcing plate is greater than the thickness of the flexible circuit board. Therefore, the thickness of the integrated circuit board provided in this application is reduced compared with that in the second conventional technology, thereby facilitating lightweight design of the electronic device.

In the first embodiment of this application, as shown in FIG. 3 and FIG. 5, the integrated circuit board 30B is installed at the first encircling wall 35 of the battery 30A, the first positive tab 33 of the battery 30A is fixedly connected to a first positive electrode connecting member 61 of the integrated circuit board 30B, and the negative tab 34 of the battery 30A is fixedly connected to a negative electrode connecting member 62 of the integrated circuit board 30B.

Refer to FIG. 2, FIG. 3, and FIG. 5. The battery module 30 is installed in the battery compartment 14, and the main circuit board 20 is installed in the circuit compartment 13. The first extension part 42 is bent relative to the packaging member 70 and the body part 41, so that the first plug connector on the main circuit board 20 and the first connecting member 80 on the integrated circuit board 30B are connected to each other, thereby implementing electrical connection between the battery module 30 and the main circuit board 20. In this way, the first positive tab 33 of the battery 30A, the integrated circuit board 30B, the first power management chip, and the negative tab 34 of the battery 30A constitute a conductive loop, and the conductive loop may supply power to components such as the display screen 200 and the central processing unit, so that the mobile phone 1000 can work normally.

More specifically, the first positive tab 33 of the battery 30A, the first positive electrode connecting member 61, the first current detection element 51, the first switch element 53, the first connecting member 80, the first power management chip, and the negative tab 34 of the battery 30A are sequentially electrically connected to form a conductive loop. The first detection chip 52 is separately electrically connected to a first end of the first current detection element 51, a second end of the first current detection element 51, the first switch element 53, and a ground terminal. The first detection chip 52 is configured to detect a current flowing through the first current detection element 51 and a voltage of the battery 30A. The current flowing through the first current detection element 51 is a current of the battery 30A. In a case in which the current or the voltage of the battery 30A is greater than a threshold, the first detection chip 52 controls the first switch element 53 to cut off, so that the conductive loop between the first positive tab 33 and the negative tab 34 of the battery 30A stops working.

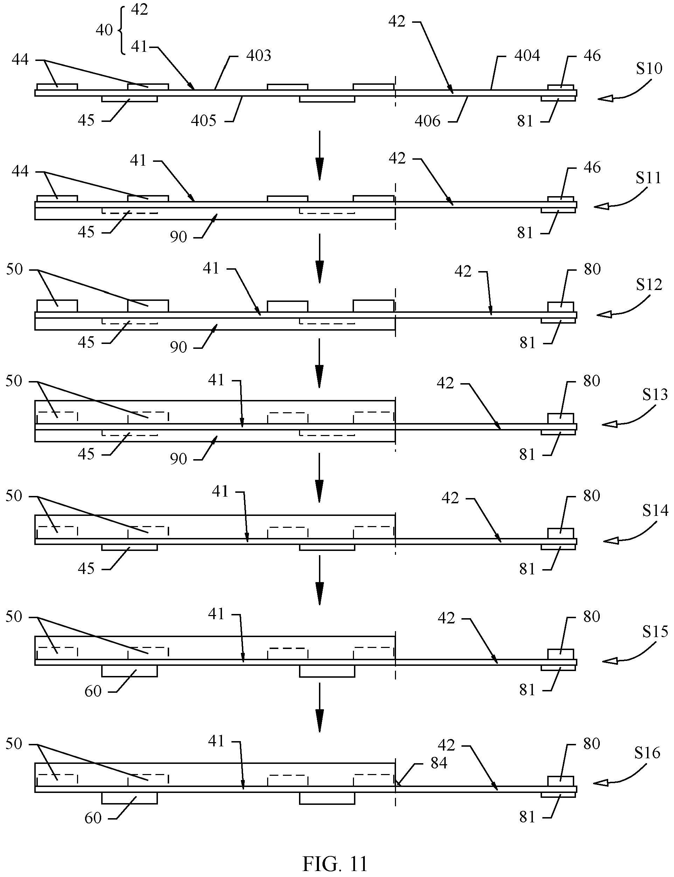

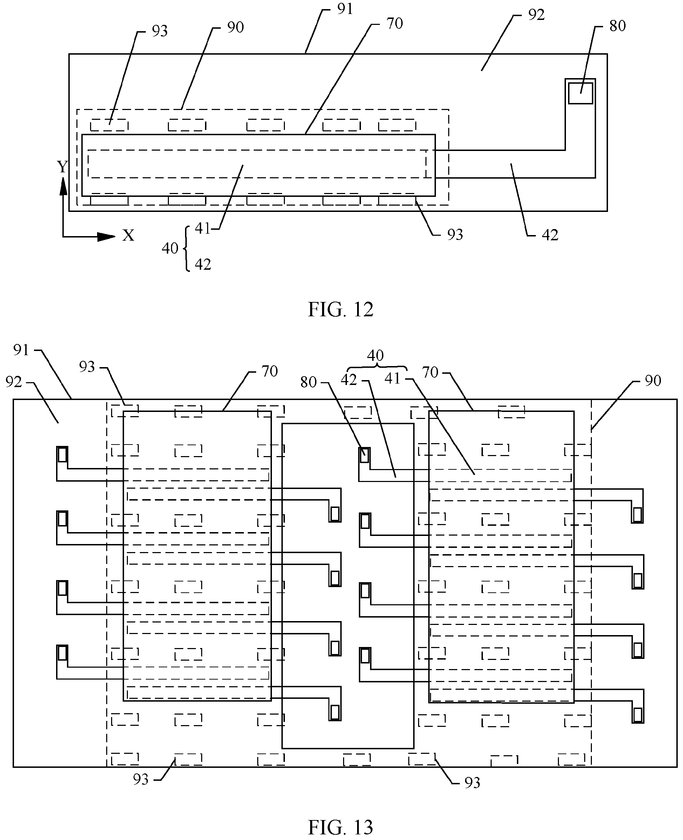

Refer to FIG. 11 and FIG. 12. FIG. 11 is a schematic diagram of a process of an integrated circuit board preparation method according to a second embodiment of this application, and FIG. 12 is a schematic diagram of step S13 in FIG. 11 in another direction.

The second embodiment of this application provides an integrated circuit board preparation method, used to prepare the integrated circuit board 30B in the first embodiment. The integrated circuit board preparation method includes the following steps.

Step S10: Provide a flexible substrate 91. The flexible substrate 91 includes a flexible circuit board 40, and the flexible circuit board 40 includes a body part 41 and a first extension part 42 that are sequentially connected. A first pad 44 and a second pad 45 are disposed on the body part 41, and the first pad 44 and the second pad 45 are located on surfaces on opposite sides of the body part 41. A first connection pad 46 and a first reinforcing plate 81 are disposed on the first extension part 42, and the first connection pad 46 and the first reinforcing plate 81 are located on surfaces on opposite sides of the first extension part 42.

It may be understood that the first pad 44, the second pad 45, and the first connection pad 46 are all pre-arranged components on the flexible substrate 91. An electrical connection relationship between the components has been set according to actual requirements.

Specifically, the first pad 44 is located on the first bearing surface 403, and the second pad 45 is located on the third bearing surface 405. There are a plurality of first pads 44 and a plurality of second pads 45. A quantity of first pads 44 is the same as a quantity of first electrical components 50 that need to be provided, and a quantity of second pads 45 is the same as a quantity of second electrical components 60 that need to be provided. The first connection pad 46 is located on the second bearing surface 404, and the first reinforcing plate 81 is located on the fourth bearing surface 406.

Step S11: Fasten an auxiliary reinforcing plate 90 to the body part 41, so that the projection of the body part 41 is completely located on the auxiliary reinforcing plate 90 in a thickness direction of the integrated circuit board. Specifically, the auxiliary reinforcing plate 90 is fixed on a side surface that is of the body part 41 and on which the second pad 45 is disposed. That is, the auxiliary reinforcing plate 90 is fastened to the third bearing surface 405. In this case, the front projection of the first pads 44 and the second pads 45 in the Z-axis direction is all located on the auxiliary reinforcing plate 90, that is, the auxiliary reinforcing plate 90 may support all the first pads 44 and the second pads 45.

Specifically, the flexible substrate 91 further includes a redundant plate 92 integrally formed with the flexible circuit board 40. The auxiliary reinforcing plate 90 is disposed on a side surface that is of the body part 41 and on which the second pad 45 is disposed, so that the auxiliary reinforcing plate 90 covers the redundant plate 92 and the flexible circuit board 40, and the auxiliary reinforcing plate 90 is bonded to the redundant plate 92 by using an adhesive 93. That is, the area of the auxiliary reinforcing plate 90 needs to be greater than the area of the flexible circuit board 40, so that the auxiliary reinforcing plate 90 can cover the flexible circuit board 40 and the redundant plate 92. Therefore, the auxiliary reinforcing plate 90 and the third bearing surface 405 can be properly fastened, and the adhesive 93 can be prevented from damaging the second pad 45.

Step S12: Fasten the first electrical component 50 to the body part 41, and fasten the first connecting member 80 to the first extension part 42. Specifically, the first electrical component 50 is welded to the first pad 44, and the first connecting member 80 is welded to the first connection pad 46. Specifically, the first electrical component 50 and the first connecting member 80 may be assembled by using a surface mount technology (surface mount technology, SMT).

Step S13: Dispose the packaging member 70 on the body part 41, so that the packaging member 70 completely covers the first electrical component 50. The packaging member 70 is specifically fastened to the first bearing surface 403 in the following manner: A mold is provided, the mold is placed on the flexible substrate 91, and the first bearing surface 403 of the body part 41 is located inside the mold. A raw material is placed in the mold, and the raw material is heated, so that the raw material becomes a liquid material; and the packaging member 70 is formed after the liquid material solidifies. The packaging member 70 may be made of epoxy resin, and the foregoing raw material is a granular material in which the epoxy resin and a curing agent are integrated. The area of the packaging member 70 needs to be greater than the area of the first bearing surface 403, so that the packaging member 70 can completely cover the first electrical component 50. The area of the packaging member 70 is less than the area of the auxiliary reinforcing plate 90, so that the packaging member 70 plays a supporting role in the molding process. The area of the packaging member 70 herein refers to the area of the surface of the packaging member 70 that is perpendicular to the Z-axis direction. The area of the auxiliary reinforcing plate 90 refers to the area of the surface of the auxiliary reinforcing plate 90 that is perpendicular to the Z-axis direction.

Step S14: Peel the auxiliary reinforcing plate 90 off from the body part 41. Specifically, the auxiliary reinforcing plate 90 may be peeled off from the flexible substrate 91 by using a laser.

Step S15: Fasten the second electrical component 60 to the body part. Specifically, the second electrical component 60 is welded to the second pad 45. Specifically, the second electrical component 60 may be assembled by using a surface assembly technology.

Step S16: Dispose a first adhesive 84 between the packaging member 70 and the first extension part 42.

It may be understood that, after the first adhesive 84 is disposed, the redundant plate 92 and the flexible circuit board 40 may be cut off to form the integrated circuit board 30B. In this case, a part of the packaging member 70 that is greater than the first bearing surface 403 is also cut off.

FIG. 13 is a schematic diagram of simultaneously processing a plurality of integrated circuit boards according to the integrated circuit board preparation method provided in the second embodiment of this application.

It may be understood that, in the foregoing integrated circuit board preparation method, a plurality of integrated circuit boards 30B may be simultaneously processed. For example, a relatively large flexible substrate 91 is provided. The flexible substrate 91 has a plurality of rows of first pads 44, a quantity of first pads 44 in each row is the same as a quantity of first electrical components 50 on one integrated circuit board 30B, and one first connection pad 46 is disposed corresponding to each row of first pads 44. That is, the flexible substrate 91 includes a plurality of flexible circuit boards 40. Therefore, in the integrated circuit board preparation method provided in this embodiment, after the second electrical component 60 is welded to the second pad 45, the integrated circuit board preparation method further includes: cutting the flexible substrate 91, and after the redundant plate 92 is removed, forming a plurality of integrated circuit boards 30B. Therefore, a plurality of integrated circuit boards 30B may be processed at a time, and processing efficiency can be improved.

In an example in which 16 integrated circuit boards 30B are simultaneously processed, the flexible substrate 91 includes a first part and a second part that are sequentially arranged in the X-axis direction. The first part has eight flexible circuit boards 40 arranged in sequence in the Y-axis direction. In the first part, in any two adjacent flexible circuit boards 40, two first welding pads are arranged in a staggered manner in the X-axis direction. The second part has eight flexible circuit boards 40 arranged in sequence in the Y-axis direction. In the second part, in any two adjacent flexible circuit boards 40, two first connection pads 46 are arranged in a staggered manner in the X-axis direction. Therefore, materials can be saved, so that a relatively large quantity of flexible circuit boards 40 can be disposed on the flexible substrate 91.

Regardless of how many flexible circuit boards 40 are disposed on the flexible substrate 91, when the packaging member 70 is being disposed, the packaging member 70 covers only the first bearing surface 403 of each flexible circuit board 40. The first bearing surfaces 403 of the flexible circuit boards 40 on the flexible substrate 91 are continuously arranged, and one packaging member 70 may cover first bearing surfaces 403 of a plurality of flexible circuit boards 40. If the first bearing surfaces 403 of the flexible circuit boards 40 on the flexible substrate 91 are arranged at intervals, a plurality of packaging members 70 are correspondingly disposed. For example, one packaging member 70 covers first bearing surfaces 403 of the eight flexible circuit boards 40 in the foregoing first part. Another packaging member 70 covers first bearing surfaces 403 of the eight flexible circuit boards 40 in the foregoing second part.

According to the integrated circuit board preparation method provided in this embodiment, the packaging member 70 is directly molded onto the body part 41, so that the packaging member 70 serves to support the body part 41 and the second electrical component 60, and protects the first electrical component 50.

In the conventional technology, the integrated circuit board 30B includes a flexible board, a second component is disposed at the bottom of the flexible board, a printed circuit board is disposed at the top of the flexible board, then a first component is disposed at the top of the printed circuit board, and the first component is packaged by using a component used for packaging. In the conventional technology, the first component is welded to the bottom of the flexible board, the printed circuit board is welded to the top of the flexible board, and the first component is welded to the top of the printed circuit board, which requires a total of three SMT operations. In this embodiment, the first electrical component 50 is directly welded to the first bearing surface 403 of the body part 41, and the second electrical component 60 is directly welded to the third bearing surface 405 of the body part 41, which requires a total of two SMT operations. A quantity of SMT operations in this embodiment is reduced compared with that in the conventional technology, and the preparation procedure is simplified.

In addition, in the integrated circuit board 30B processed in this embodiment, the packaging member 70 directly packages all the first electrical components 50 on the body part 41. The length, the width, and the thickness of the packaging member 70 are reduced compared with those in the conventional technology, so that the length, the width, and the thickness of the integrated circuit board 30B are reduced compared with those in the conventional technology, thereby facilitating lightweight design of the electronic device.

In this embodiment, the thickness of the thickest area of the processed integrated circuit board 30B in the Z-axis direction is a sum of the thickness of the packaging member 70, the thickness of the flexible circuit board 40, and the thickness of the second electrical component 60. In the conventional technology, the integrated circuit board 30B generally includes a printed circuit board (printed circuit boards, PCB), a flexible circuit board 40, and a packaging member 70. The thickness of the integrated circuit board 30B in the thickest area in the Z-axis direction in the conventional technology is a sum of the thickness of the printed circuit board, the thickness of the packaging member 70, and the thickness of the electrical component. The thickness of the printed circuit board is greater than the thickness of the flexible circuit board 40. Therefore, the thickness of the integrated circuit board 30B prepared in this embodiment is reduced compared with that in the conventional technology, which facilitates lightweight design of the electronic device.

In addition, when the first electrical component 50 is welded to the first pad 44, the auxiliary reinforcing plate 90 is fastened to the flexible circuit board 40. In this case, the auxiliary reinforcing plate 90 serves to support the body part 41 of the flexible circuit board 40, so as to ensure that the body part 41 is in a flat state, avoid a dead broken line of the body part 41, and reduce a risk of a welding failure of the first electrical component 50. When the second electrical component 60 is welded to the second pad 45, the packaging member 70 serves to support the body part 41, so as to facilitate welding of the second electrical component 60, and reduce a risk of a welding failure of the second electrical component.

A third embodiment of this application provides an electronic device. The electronic device is a mobile phone. The mobile phone includes a display screen and a body.

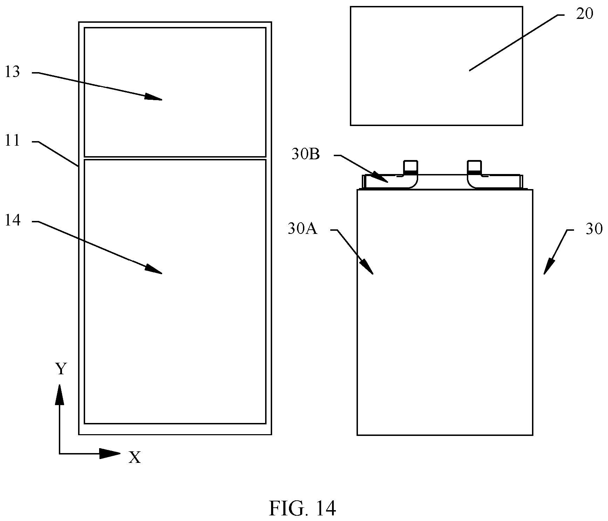

FIG. 14 is a schematic diagram of an exploded structure of the mobile phone according to the third embodiment of this application.

In this embodiment, the body includes a housing, a main circuit board 20, and a battery module 30. Both the main circuit board 20 and the battery module 30 are installed inside the housing. The main circuit board 20 is integrated with components such as a first power management chip (not shown in the figure), a second power management chip, a central processing unit (not shown in the figure), a first connecting member 80, and a second plug connector. Both the first plug connector and the second plug connector are female ends of a board-to-board connector, and both the first plug connector and the second plug connector are configured to be connected to the battery module 30, so as to implement electrical connection between the main circuit board 20 and the battery module 30. Both the first power management chip and the second power management chip are configured to manage information such as an electricity quantity of the battery 30A, a charging state, and display screen brightness.

The battery module 30 includes the battery 30A and an integrated circuit board 30B. The battery 30A, the integrated circuit board 30B, and the first power management chip are electrically connected in sequence, and the battery 30A supplies power to components such as the central processing unit (not shown in the figure) and the display screen through the integrated circuit board 30B and the first power management chip. The battery 30A, the integrated circuit board 30B, and the second power management chip are electrically connected in sequence, and the battery 30A supplies power to components such as the central processing unit (not shown in the figure) and the display screen through the integrated circuit board 30B and the second power management chip.

The housing includes a middle frame 11 and a rear cover. The middle frame 11 includes a middle plate and a side frame, and the middle plate and the side frame enclose an accommodating cavity. The rear cover is fixed on a side of the side frame along the Z-axis direction, and the rear cover closes the accommodating cavity. The display screen is mounted on a side that is of the middle frame 11 and that is away from the rear cover. Specifically, the accommodating cavity includes a circuit compartment 13 and a battery compartment 14. The circuit compartment 13 is configured to install the main circuit board 20, and the battery compartment 14 is configured to install the battery module 30.

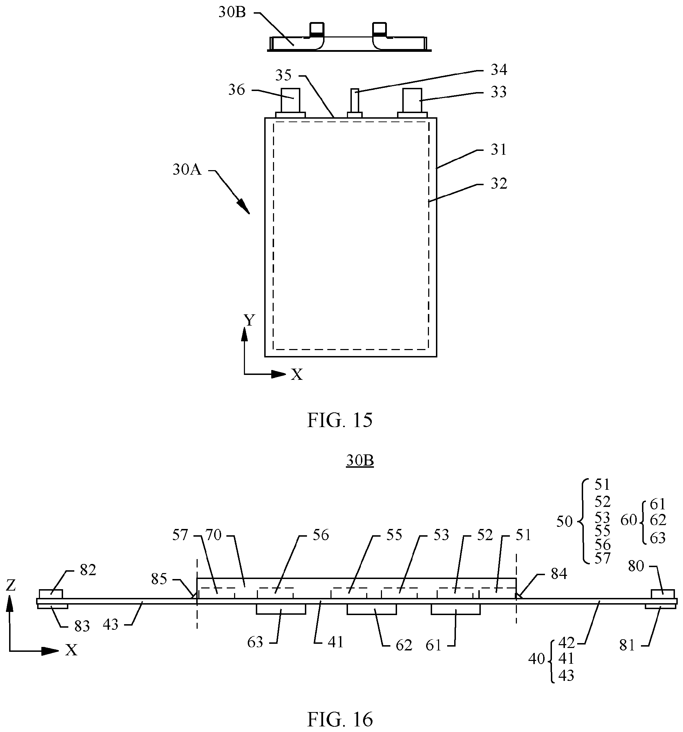

FIG. 15 is a schematic diagram of an exploded structure of the battery module of the mobile phone shown in FIG. 14.

The battery 30A of the battery module 30 includes an enclosure 31 and a bare cell 32. The bare cell 32 includes first electrode plates (not shown in the figure) and second electrode plates (not shown in the figure), an isolation film is disposed between adjacent first electrode plate and second electrode plate, and the isolation film is used to insulate the first electrode plate and the second electrode plate. The first electrode plate has a first positive tab 33 and a second positive tab 36, and the second electrode plate has a negative tab 34. In another embodiment, the first electrode plate, the second electrode plate, and the isolation film may be wound into the bare cell 32.

The bare cell 32 is installed in a receiving cavity of the enclosure 31, and the first positive tab 33, the second positive tab 36, and the negative tab 34 all protrude from the first encircling wall 35, and electrolyte is filled in the receiving cavity.

FIG. 16 is a schematic diagram of a structure of the integrated circuit board of the battery module shown in FIG. 14.

The integrated circuit board 30B of the battery module 30 includes a flexible printed circuit (flexible printed circuit, FPC) board 40, a first electrical component 50, a second electrical component 60, a packaging member 70, a first connecting member 80, a second connecting member 82, a first reinforcing plate 81, and a second reinforcing plate 83.

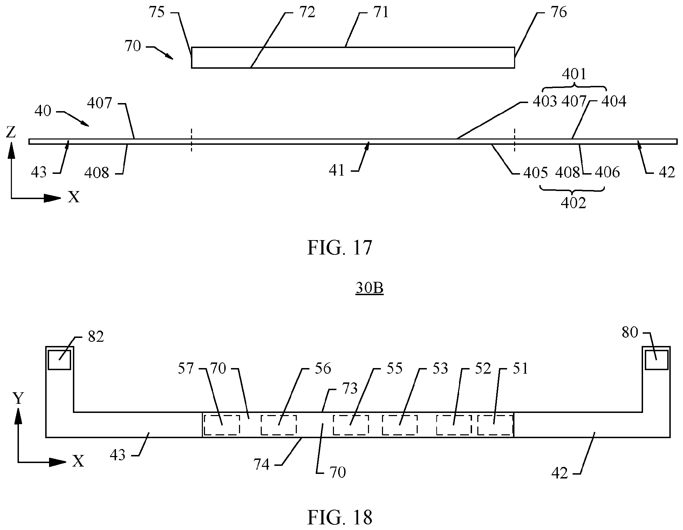

FIG. 17 is a schematic diagram of an exploded structure of a partial structure of the integrated circuit board shown in FIG. 16.

The flexible circuit board 40 is rectangular in shape, and the flexible circuit board 40 has a first surface 401 and a second surface 402 that are opposite to each other in the Z-axis direction. The first surface 401 includes a first bearing surface 403, a second bearing surface 404, and a fifth bearing surface 407. The fifth bearing surface 407, the first bearing surface 403, and the second bearing surface 404 are sequentially connected in the X-axis direction. The second surface 402 includes a third bearing surface 405, a fourth bearing surface 406, and a sixth bearing surface 408. The sixth bearing surface 408, the third bearing surface 405, and the fourth bearing surface 406 are sequentially connected in the X-axis direction.

The flexible circuit board 40 includes a body part 41, a first extension part 42, and a second extension part 43. The second extension part 43, the body part 41, and the first extension part 42 are sequentially connected in the X-axis direction. The first bearing surface 403 and the third bearing surface 405 are located on two sides of the body part 41 that are opposite to each other in the Z-axis direction, and the second bearing surface 404 and the fourth bearing surface 406 are located on two sides of the first extension part 42 that are opposite to each other in the Z-axis direction. The fifth bearing surface 407 and the sixth bearing surface 408 are located on two sides of the second extension part 43 that are opposite to each other in the Z-axis direction.

FIG. 18 is a schematic diagram of a structure of the integrated circuit board shown in FIG. 16 in another direction.

The first extension part 42 includes a first extension section and a second extension section, and the first extension section and the second extension section are connected at an angle. An end of the first extension section away from the second extension section is connected to the body part, and the first connecting member 80 is disposed at an end of the second extension section away from the first extension section. The second extension part 43 includes a third extension section and a fourth extension section, and the third extension section and the fourth extension section are connected at an angle. An end of the third extension section away from the fourth extension section is connected to the body part, and the second connecting member 82 is disposed at an end of the fourth extension section away from the third extension section.

Refer to FIG. 16. The first electrical component 50 is an electronic component integrated on the first bearing surface 403, and the second electrical component 60 is an electronic component integrated on the third bearing surface 405. The first electrical component 50 includes a first current detection element 51, a second current detection element 55, a first protection unit, and a second protection unit, and the first protection unit includes a first detection chip 52 and a first switch element 53. The second protection unit includes a second detection chip 56 and a second switch element 57.

The second electrical component 60 includes a first positive electrode connecting member 61, a second positive electrode connecting member 63, and a negative electrode connecting member 62. The second positive electrode connecting member 63 is configured to connect to the second positive tab 36.

Refer to FIG. 17. The packaging member 70 is a hard member made of an insulating material such as epoxy resin. The packaging member 70 is stacked on the first bearing surface 403 of the body part 41 of the flexible circuit board 40, and the packaging member 70 covers the first electrical component 50. The packaging member 70 has a first package surface 71 and a second package surface 72 that are opposite to each other in the Z-axis direction, has a first package side 73 and a second package side 74 that are opposite to each other in the Y-axis direction, and a first package end 75 and a second package end 76 that are opposite to each other in the X-axis direction. For a shape and a size of the packaging member 70, a connection manner between the packaging member 70 and the body part 41, and a position relationship between the packaging member 70 and the first electrical component 50, refer to the description in the first embodiment.

The first connecting member 80 is integrated on the second bearing surface 404 of the first extension part 42. The second connecting member 82 is integrated on the fifth bearing surface 407 of the second extension part 43, and the second connecting member 82 is a male end of a board-to-board connector. The second connecting member 82 is configured to interconnect with a second plug connector disposed on the main circuit board 20, and the second connector is a female end of the board-to-board connector.

After the packaging member 70 is packaged on the body part 41, the body part 41 and the packaging member 70 form an integral structure, so as to support the body part 41 to protect the first electrical component 50. In addition, the projection of the second electrical component 60 in the Z-axis direction is completely located on the packaging member 70, that is, the packaging member 70 further supports the second electrical component 60. In this case, the first extension part 42 keeps in a flexible state, and the first extension part 42 may bend relative to the packaging member 70 and the body part 41. The second extension part 43 keeps in a flexible state, and the second extension part 43 may bend relative to the packaging member 70 and the body part 41.

In this embodiment, as shown in FIG. 16, a first adhesive 84 is disposed between the second package end 76 of the packaging member 70 and the second bearing surface 404 of the first extension part 42. A shape and a connection manner of the first adhesive 84 are the same as those in the foregoing first embodiment.

In this embodiment, as shown in FIG. 16, a second adhesive 85 is disposed between the first package end 75 of the packaging member 70 and the fifth bearing surface 407 of the second extension part 43. A cross-section of the second adhesive 85 is a triangle. The second adhesive 85 has a third adhesive surface, a fourth adhesive surface, and a second connection surface, and the third adhesive surface, the fourth adhesive surface, and the second connection surface are connected end to end in sequence. The third adhesive surface is bonded to the packaging member 70, and the fourth adhesive surface is bonded to the second extension part 43. The second adhesive 85 has a relatively regular shape and does not generate a spike, thereby reducing a risk of being stabbed when the second extension part 43 is bent.

In this embodiment, the first connecting member 80 is integrated on the second bearing surface 404 of the first extension part 42, and the first reinforcing plate 81 is fastened to the fourth bearing surface 406. The second connecting member 82 is integrated on the fifth bearing surface 407 of the second extension part 43, and the second reinforcing plate 83 is integrated on the sixth bearing surface 408 of the second extension part 43. In another embodiment, the second connecting member 82 is integrated on the sixth bearing surface 408 of the second extension part 43, and the second reinforcing plate 83 is integrated on the fifth bearing surface 407 of the second extension part 43.

In this embodiment, the thickness of the integrated circuit board 30B in the Z-axis direction is less than the thickness of the circuit board in the conventional technology, and the length, the width, and the thickness of the packaging member 70 are all less than the length, the width, and the thickness of the package component in the conventional technology. Therefore, the length, the width, and the thickness of the integrated circuit board 30B are further reduced compared with those in the conventional technology, and this is conducive to lightweight design of the electronic device.

In this embodiment, the integrated circuit board 30B is installed at the first encircling wall 35 of the battery 30A, the first positive tab 33 of the battery 30A is fixedly connected to the first positive electrode connecting member 61 of the integrated circuit board 30B, the second positive tab 36 of the battery 30A is fixedly connected to the second positive electrode connecting member 63 of the integrated circuit board 30B, and the negative tab 34 of the battery 30A is fixedly connected to the negative electrode connecting member 62 of the integrated circuit board 30B.

The battery module 30 is installed in the battery compartment 14, and the main circuit board 20 is installed in the circuit compartment 13. The first extension part 42 is bent relative to the body part 41 and the packaging member 70, so that the first plug connector on the main circuit board 20 and the first connecting member 80 on the integrated circuit board 30B are connected to each other, thereby implementing electrical connection between the battery module 30 and the main circuit board 20. In this way, the first positive tab 33 of the battery 30A, the integrated circuit board 30B, the first power management chip, and the negative tab 34 of the battery 30A constitute a conductive loop, and the conductive loop may supply power to components such as the display screen and the central processing unit, so that the mobile phone can work normally.

The second extension part 43 is externally folded relative to the body part 41 and the packaging member 70, so that the second plug connector on the main circuit board 20 and the second connecting member 82 on the integrated circuit board 30B are connected to each other, thereby implementing electrical connection between the battery module 30 and the main circuit board 20. Therefore, the second positive tab 36 of the battery 30A, the integrated circuit board 30B, the second power management chip, and the negative tab 34 of the battery 30A constitute a conductive loop, and the conductive loop may supply power to components such as the display screen and the central processing unit, so that the mobile phone can work normally. More specifically, the second positive tab 36 of the battery 30A, the second positive electrode connecting member 63, the second current detection element 55, the second switch element 57, the second connecting member 82, the second power management chip, and the negative tab 34 of the battery 30A are sequentially electrically connected to form a conductive loop. The second detection chip 56 is electrically connected to the first end of the second current detection element 55, the second end of the second current detection element 55, the second switch element 57, and the ground terminal. The second detection chip 56 is configured to detect a current flowing through the second current detection element 55 and a voltage of the battery 30A. The current flowing through the second current detection element 55 is a current of the battery 30A. In a case in which the current or the voltage of the battery 30A is greater than a threshold, the second detection chip 56 controls the second switch element 57 to cut off, so that the conductive loop between the second positive tab 36 and the negative tab 34 of the battery 30A stops working.

In other words, in this embodiment, the mobile phone has two conductive loops, which can improve charging and discharging efficiency, reduce heat generated by the battery 30A, delay attenuation of the battery 30A capacity, and increase a service life of the battery 30A.

In another embodiment, the battery 30A may further be provided with a third positive tab, a fourth positive tab, and the like. Correspondingly, a third positive electrode connecting member, a fourth positive electrode connecting member, and the like are disposed on the corresponding protection circuit board, and a third connecting member, a fourth connecting member, and the like are disposed. A third power management chip, a fourth power management chip, a third plug connector, a fourth plug connector, and the like are correspondingly disposed on the main circuit board 20. In this way, the battery 30A has more conductive loops.

In another embodiment, the battery 30Amay also have a plurality of negative tabs, such as a first negative tab, a second negative tab, and a third negative tab. One negative tab may be used for negative electrodes of one or more conductive loops.

A fourth embodiment of this application further provides an integrated circuit board preparation method, used to prepare the integrated circuit board 30B in the third embodiment.

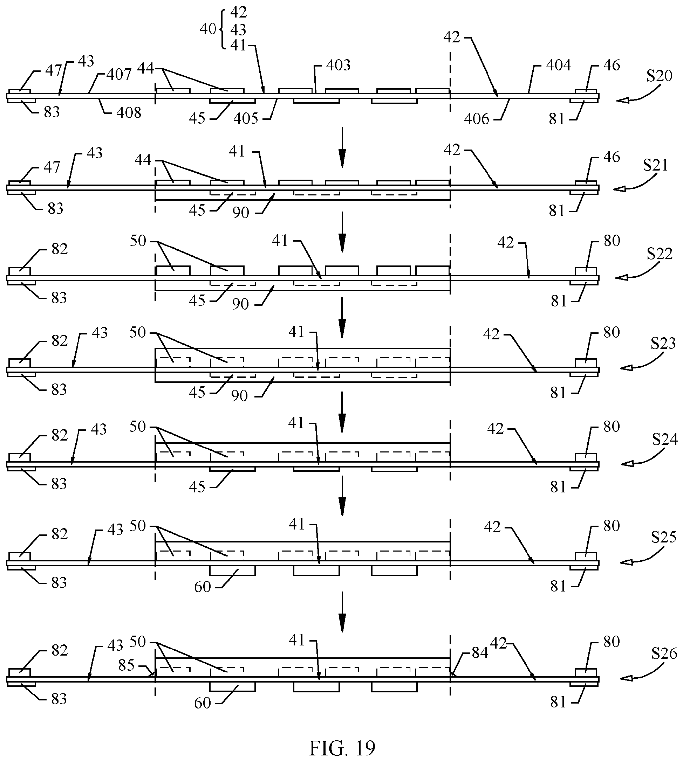

FIG. 19 is a schematic diagram of a process of an integrated circuit board preparation method according to the fourth embodiment of this application. The integrated circuit board preparation method includes the following steps.

Step S20: Provide a flexible substrate. The flexible substrate includes a flexible circuit board 40, and the flexible circuit board 40 includes a second extension part 43, a body part 41, and a first extension part 42 that are sequentially connected. A first pad 44 and a second pad 45 are disposed on the body part 41, and the first pad 44 and the second pad 45 are located on surfaces on opposite sides of the body part 41. A first connection pad 46 and a first reinforcing plate 81 are disposed on the first extension part 42, and the first connection pad 46 and the first reinforcing plate 81 are located on surfaces on opposite sides of the first extension part 42. A second connection pad 47 and a second reinforcing plate 83 are disposed on the second extension part 43, and the second connection pad 47 and the second reinforcing plate 83 are located on surfaces on opposite sides of the second extension part 43.

It may be understood that the first pad 44, the second pad 45, the first connection pad 46, and the second connection pad 47 are all pre-arranged components on the flexible substrate 91. An electrical connection relationship between the components has been set according to actual requirements.

Specifically, the first pad 44 is located on the first bearing surface 403, and the second pad 45 is located on the third bearing surface 405. There are a plurality of first pads 44 and a plurality of second pads 45. A quantity of first pads 44 is the same as a quantity of first electrical components 50 that need to be provided, and a quantity of second pads 45 is the same as a quantity of second electrical components 60 that need to be provided. The first connection pad 46 is located on the fifth bearing surface 407, and the second reinforcing plate 83 is located on the sixth bearing surface 408.

Step S21: Fasten an auxiliary reinforcing plate 90 to the body part 41, so that the projection of the body part 41 is completely located on the auxiliary reinforcing plate 90 in a thickness direction of the integrated circuit board. Specifically, the auxiliary reinforcing plate 90 is fixed on a side surface that is of the body part 41 and on which the second pad 45 is disposed. That is, the auxiliary reinforcing plate 90 is fastened to the third bearing surface 405. In this case, the front projection of the first pads 44 and the second pads 45 in the Z-axis direction is all located on the auxiliary reinforcing plate 90, that is, the auxiliary reinforcing plate 90 may support all the first pads 44 and the second pads 45.

Specifically, the flexible substrate further includes a redundant plate integrally formed with the flexible circuit board 40. The auxiliary reinforcing plate 90 is disposed on a side surface that is of the body part 41 and on which the second pad 45 is disposed, so that the auxiliary reinforcing plate 90 covers the redundant plate and the flexible circuit board 40, and the auxiliary reinforcing plate 90 is bonded to the redundant plate by using an adhesive. Therefore, the auxiliary reinforcing plate 90 and the third bearing surface 405 can be properly fastened, and the adhesive can be prevented from damaging the second pad 45.

Step S22: Fasten the first electrical component 50 to the body part 41, fasten the first connecting member 80 to the first extension part 42, and fasten the second connecting member 82 to the second extension part 43. Specifically, the first electrical component 50 is welded to the first pad 44, the first connecting member 80 is welded to the first connection pad 46, and the second connecting member 82 is welded to the second connection pad 47. Specifically, the first electrical component 50, the first connecting member 80, and the second connecting member 82 may be assembled by using a surface mount technology (surface mount technology, SMT).

Step S23: The packaging member 70 is disposed on the body part 41, so that the packaging member 70 completely covers the first electrical component 50. The packaging member 70 is specifically fastened to the first bearing surface 403 in the following manner: A mold is provided, the mold is placed on the flexible substrate 91, and the first bearing surface 403 of the body part 41 is located inside the mold. A raw material is placed in the mold, and the raw material is heated, so that the raw material becomes a liquid material; and the packaging member 70 is formed after the liquid material solidifies. The packaging member 70 may be made of epoxy resin, and the foregoing raw material is a granular material in which the epoxy resin and a curing agent are integrated.

Step S24: Peel the auxiliary reinforcing plate 90 off from the body part 41. Specifically, the auxiliary reinforcing plate 90 may be peeled off from the flexible substrate by using a laser.

Step S25: Fasten the second electrical component 60 to the body part. Specifically, the second electrical component 60 is welded to the second pad 45. Specifically, the second electrical component 60 may be assembled by using a surface assembly technology.

Step S26: Dispose a first adhesive 84 between the packaging member 70 and the first extension part 42, and dispose a second adhesive 85 between the packaging member 70 and the second extension part 43.

It may be understood that, in the foregoing integrated circuit board preparation method, a plurality of integrated circuit boards 30B may be simultaneously processed, for example, a large-area flexible substrate is provided, and the flexible substrate includes a plurality of flexible circuit boards 40. After the second electrical component 60 is welded to the second pad 45, the integrated circuit board preparation method further includes: cutting the flexible substrate 91, and after the redundant plate 92 is removed, forming a plurality of integrated circuit boards 30B. Therefore, a plurality of integrated circuit boards 30B may be processed at a time, and processing efficiency can be improved.

According to the integrated circuit board preparation method provided in this embodiment, the packaging member 70 is directly molded onto the body part 41, so that the packaging member 70 serves to support the body part 41 and the second electrical component 60, and protects the first electrical component 50. The first electrical component 50 is directly welded to the first bearing surface 403 of the body part 41, and the second electrical component 60 is directly welded to the third bearing surface 405 of the body part 41, which requires a total of two SMT operations. A quantity of SMT operations in this embodiment is reduced compared with that in the conventional technology, and the preparation procedure is simplified.

In addition, in the integrated circuit board 30B processed in this embodiment, the packaging member 70 directly packages all the first electrical components 50 on the body part 41. The length, the width, and the thickness of the packaging member 70 are reduced compared with those in the conventional technology, so that the length, the width, and the thickness of the integrated circuit board 30B are reduced compared with those in the conventional technology, thereby facilitating lightweight design of the electronic device. Compared with the conventional technology, the integrated circuit board 30B provided in this embodiment does not need a printed circuit board. Therefore, a thickness dimension is reduced, which facilitates lightweight design of the electronic device.

In addition, when the first electrical component 50 is welded to the first pad 44, the auxiliary reinforcing plate 90 is fastened to the flexible circuit board 40. In this case, the auxiliary reinforcing plate 90 serves to support the body part 41 of the flexible circuit board 40, so as to ensure that the body part 41 is in a flat state, avoid a dead broken line of the body part 41, and reduce a risk of a welding failure of the first electrical component 50. When the second electrical component 60 is welded to the second pad 45, the packaging member 70 serves to support the body part 41, so as to facilitate welding of the second electrical component 60, and reduce a risk of a welding failure of the second electrical component.

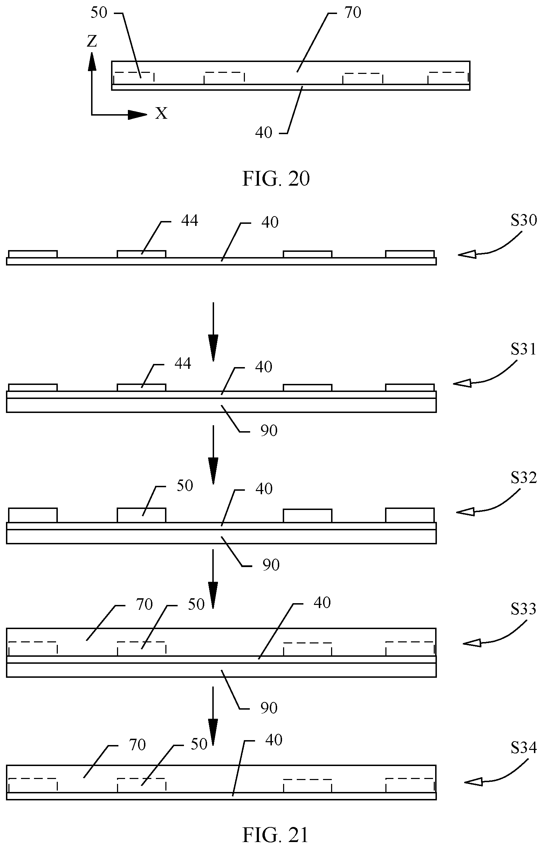

FIG. 20 is a schematic diagram of a structure of an integrated circuit board according to a fifth embodiment of this application.

The fifth embodiment of this application provides an integrated circuit board 30B, including a flexible circuit board 40, a first electrical component 50, and a packaging member 70. The first electrical component 50 is disposed on a side surface of the flexible circuit board 40. The packaging member 70 is fastened to the flexible circuit board 40, and the packaging member 70 covers the first electrical component 50. The first electrical component 50 may be a resistor, a capacitor, an inductor, a detection chip, an anti-counterfeit chip 54, or the like. The integrated circuit board 30B may be applied to various electronic devices such as a cellphone (cellphone), a notebook computer (notebook computer), a tablet personal computer (tablet personal computer), a personal digital assistant (personal digital assistant), a wearable device (wearable device), or a mobile device (mobile device).

In this embodiment, for a shape and a size of the packaging member 70 and a manner of connecting to the flexible circuit board 40, refer to the description in the first embodiment.

In this embodiment, the packaging member 70 is directly connected to the flexible circuit board 40, and covers the first electrical component 50. Compared with the conventional technology in which a printed circuit board needs to be disposed, the thickness of the integrated circuit board 30B is reduced. Compared with the conventional technology in which the first electrical component 50 is separately packaged, the length, the width, and the thickness of the packaging member 70 are reduced, so that the length, the width, and the thickness of the integrated circuit board 30B are reduced.

A sixth embodiment of this application provides an integrated circuit board preparation method, used to prepare the integrated circuit board 30B in the fifth embodiment.

FIG. 21 is a schematic diagram of a process of the integrated circuit board preparation method according to the sixth embodiment of this application. The integrated circuit board preparation method includes the following steps.

Step S30: Provide a flexible substrate, where the flexible substrate includes a flexible circuit board 40, and a first pad 44 is disposed on a surface of a side of the flexible circuit board 40.

Step S31: Fasten an auxiliary reinforcing plate 90 to the flexible circuit board 40, so that the projection of the flexible circuit board 40 is completely located on the auxiliary reinforcing plate 90 in a thickness direction of the integrated circuit board. Specifically, the auxiliary reinforcing plate 90 is fixed on a side surface of the flexible circuit board 40 that is away from the first pad 44. Specifically, the flexible substrate further includes a redundant plate formed integrally with the flexible circuit board 40, and the auxiliary reinforcing plate 90 is bonded to the redundant plate by using an adhesive, so that the adhesive is staggered from the flexible circuit board 40.

Step S32: Fasten the first electrical component 50 to the flexible circuit board 40. Specifically, the first electrical component 50 is welded to the first pad 44. Specifically, the first electrical component 50 may be assembled in an SMT manner.

Step S33: Fasten the packaging member 70 to the body part 41, so that the packaging member 70 completely covers the first electrical component 50. The packaging member 70 is specifically fastened to the first bearing surface 403 in the following manner: A mold is provided, so that a side on which the first electrical component 50 is mounted on the flexible circuit board 40 is located inside the mold; a raw material is placed in the mold, and the raw material is heated, so that the raw material becomes a liquid material; and the packaging member 70 is formed after the liquid material solidifies.

Step S34: Peel the auxiliary reinforcing plate 90 off from the flexible circuit board 40. Specifically, the auxiliary reinforcing plate 90 may be peeled off from the flexible circuit board 40 by using a laser.

It may be understood that, in the foregoing integrated circuit board preparation method, a plurality of integrated circuit boards 30B may be simultaneously processed, for example, a large-area flexible substrate is provided, and the flexible substrate includes a plurality of flexible circuit boards 40. After the auxiliary reinforcing plate 90 is peeled off from the flexible circuit board 40, the integrated circuit board preparation method further includes: cutting the flexible substrate 91, and after the redundant plate 92 is removed, forming a plurality of integrated circuit boards 30B. Therefore, a plurality of integrated circuit boards 30B may be processed at a time, and processing efficiency can be improved.

The integrated circuit board 30B processed by using the integrated circuit board preparation method provided in this embodiment has a relatively small size. When the integrated circuit board 30B is applied to an electronic device, occupied space is relatively small, which facilitates lightweight design of the electronic device.

In addition, when the first electrical component 50 is welded to the first pad 44, the auxiliary reinforcing plate 90 is fastened to the flexible circuit board 40. In this case, the auxiliary reinforcing plate 90 serves to support the flexible circuit board 40, so as to ensure that the flexible circuit board 40 is in a flat state, avoid a dead broken line of the flexible circuit board 40, and reduce a risk of a welding failure of the first electrical component 50.

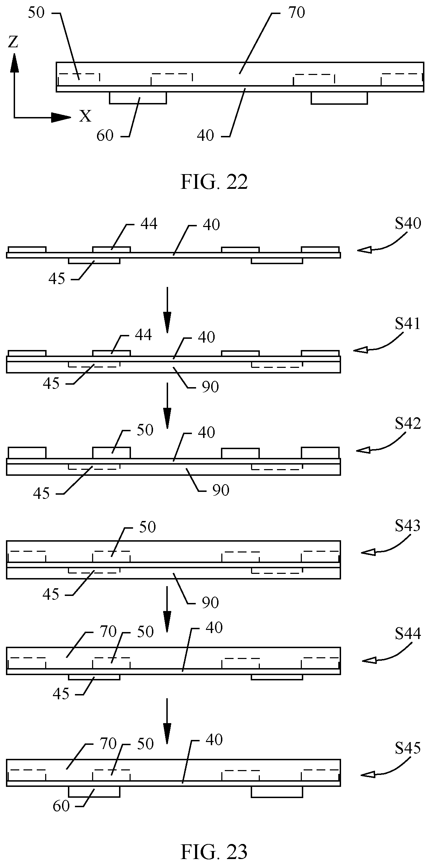

FIG. 22 is a schematic diagram of a structure of an integrated circuit board according to a seventh embodiment of this application.

The seventh embodiment of this application provides an integrated circuit board 30B, including a flexible circuit board 40, a first electrical component 50, a second electrical component 60, and a packaging member 70. The flexible circuit board 40, the first electrical component 50, and the packaging member 70 are included. The first electrical component 50 is disposed on a surface of a side of the flexible circuit board 40. The second electrical component 60 is fixed on a surface of a side of the flexible circuit board 40 that is away from the first electrical component 50. That is, the first electrical component 50 and the second electrical component 60 are respectively fixed on the surfaces of opposite sides of the flexible circuit board 40. The packaging member 70 is fastened to the flexible circuit board 40, and the packaging member 70 covers the first electrical component 50. The first electrical component 50 and the second electrical component 60 may be a resistor, a capacitor, an inductor, a detection chip, an anti-counterfeit chip 54, or the like. The integrated circuit board 30B may be applied to various electronic devices such as a cellphone (cellphone), a notebook computer (notebook computer), a tablet personal computer (tablet personal computer), a personal digital assistant (personal digital assistant), a wearable device (wearable device), or a mobile device (mobile device).

In this embodiment, for a shape and a size of the packaging member 70 and a manner of connecting to the flexible circuit board 40, refer to the description in the first embodiment.

In this embodiment, the packaging member 70 is directly connected to the flexible circuit board 40, and covers the first electrical component 50. Compared with the conventional technology in which a printed circuit board needs to be disposed, the thickness of the integrated circuit board 30B is reduced. Compared with the conventional technology in which the first electrical component 50 is separately packaged, the length, the width, and the thickness of the packaging member 70 are reduced, so that the length, the width, and the thickness of the integrated circuit board 30B are reduced.

An eighth embodiment of this application provides an integrated circuit board preparation method, used to prepare the integrated circuit board 30B in the seventh embodiment.

FIG. 23 is a schematic diagram of a process of the integrated circuit board preparation method according to the eighth embodiment of this application. The integrated circuit board preparation method includes the following steps.

Step S40: Provide a flexible substrate, where the flexible substrate includes a flexible circuit board 40, a first pad 44 is disposed on a surface of a side of the flexible circuit board 40, and a second pad 45 is disposed on a surface of another side of the flexible circuit board 40.

Step S41: Fasten an auxiliary reinforcing plate 90 to the flexible circuit board 40, so that the projection of the flexible circuit board 40 is completely located on the auxiliary reinforcing plate 90 in a thickness direction of the integrated circuit board. Specifically, the auxiliary reinforcing plate 90 is fixed on a side surface of the flexible circuit board 40 that is away from the first pad 44. Specifically, the flexible substrate further includes a redundant plate formed integrally with the flexible circuit board 40, and the auxiliary reinforcing plate 90 is bonded to the redundant plate by using an adhesive, so that the adhesive is staggered from the second pad 45.

Step S42: Fasten the first electrical component 50 to the flexible circuit board 40. Specifically, the first electrical component 50 is welded to the first pad 44. Specifically, the first electrical component 50 may be assembled in an SMT manner.

Step S43: Fasten the packaging member 70 to the body part 41, so that the packaging member 70 covers the first electrical component 50. The packaging member 70 is specifically fastened to the first bearing surface 403 in the following manner: A mold is provided, so that a side on which the first electrical component 50 is mounted on the flexible circuit board 40 is located inside the mold; a raw material is placed in the mold, and the raw material is heated, so that the raw material becomes a liquid material; and the packaging member 70 is formed after the liquid material solidifies. Here, the raw material is a granular material in which epoxy resin and a curing agent are integrated.

Step S44: Peel the auxiliary reinforcing plate 90 off from the flexible circuit board 40. Specifically, the auxiliary reinforcing plate 90 may be peeled off from the flexible circuit board 40 by using a laser.

Step S45: Fasten the second electrical component 60 to the flexible circuit board 40. Specifically, the second electrical component 60 is welded to the second pad 45. Specifically, the second electrical component 60 may be assembled in an SMT manner.

It may be understood that, in the foregoing integrated circuit board preparation method, a plurality of integrated circuit boards 30B may be simultaneously processed, for example, a large-area flexible substrate is provided, and the flexible substrate includes a plurality of flexible circuit boards 40. After the auxiliary reinforcing plate 90 is peeled off from the flexible circuit board 40, the integrated circuit board preparation method further includes: cutting the flexible substrate 91, and after the redundant plate 92 is removed, forming a plurality of integrated circuit boards 30B. Therefore, a plurality of integrated circuit boards 30B may be processed at a time, and processing efficiency can be improved.

The integrated circuit board 30B processed by using the integrated circuit board preparation method provided in this embodiment has a relatively small size. When the integrated circuit board 30B is applied to an electronic device, occupied space is relatively small, which facilitates lightweight design of the electronic device.

In addition, when the first electrical component 50 is welded to the first pad 44, the auxiliary reinforcing plate 90 is fastened to the flexible circuit board 40. In this case, the auxiliary reinforcing plate 90 serves to support the flexible circuit board 40, so as to ensure that the flexible circuit board 40 is in a flat state, avoid a dead broken line of the flexible circuit board 40, and reduce a risk of a welding failure of the first electrical component 50. When the second electrical component 60 is welded to the second pad 45, the packaging member 70 serves to support the flexible circuit board 40, so that the second electrical component 60 is welded. A risk of a welding failure of the second electrical component is reduced.

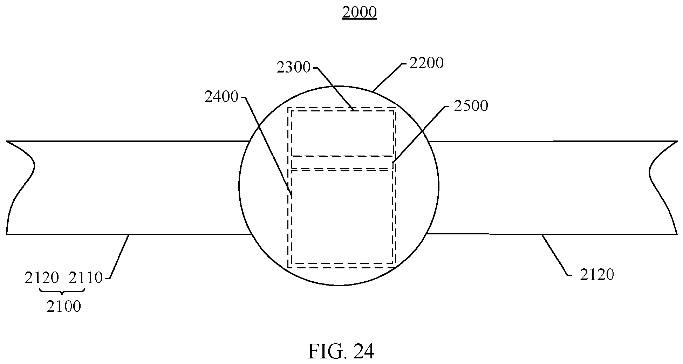

A ninth embodiment of this application provides an electronic device. FIG. 24 is a schematic diagram of a structure of a wearable device according to the ninth embodiment of this application.

The electronic device is a wearable device 2000, and may be specifically a wearable watch or band. The wearable device 2000 includes a display screen (not shown in the figure) and a body.

The display screen has a touch function, and is configured to operate the mobile phone and display information such as an image and a video. The display screen includes a display surface and a mounting surface, the display screen is mounted on the body, the mounting surface of the display screen faces the body, and the display surface of the display screen faces away from the body.

The display screen may be specifically an organic light-emitting diode (organic light-emitting diode, OLED) display screen, an active-matrix organic light-emitting diode (active-matrix organic light-emitting diode, AMOLED) display screen, a mini organic light-emitting diode (mini organic lightemitting diode) display screen, a micro light-emitting diode (micro organic light-emitting diode) display screen, a micro organic light-emitting diode (micro organic light-emitting diode) display screen, or a quantum dot light-emitting diode (quantum dot light emitting diodes, QLED) display screen.

The body includes a wearing strip 2100, a housing 2200, a main circuit board 2300, and a battery 2400. The housing 2200 is provided with an accommodating cavity. The accommodating cavity includes a circuit compartment and a battery compartment, the main circuit board 2300 is installed in the circuit compartment, and the battery 2400 is installed in the battery compartment. The main circuit board 2300 is integrated with components such as a first power management chip and a central processing unit (not shown in the figure). An integrated circuit board 2500 is disposed on the battery 2400.

The wearing strip 2100 is made of a flexible material such as a steel chain, canvas, plastic, and nylon. The wearing strip 2100 includes a first wearing part 2110 and a second wearing part 2120. One end of the first wearing part 2110 is connected to one end of the housing 2200, one end of the second wearing part 2120 is connected to the other end of the housing 2200, and the other end of the first wearing part 2110 and the other end of the second wearing part 2120 are removably connected. The wearing strip 2100 may enable the user to wear the wearable electronic device on a limb such as a wrist, an ankle, an arm, or a leg.

For structures, a connection relationship, working principles, and the like of the housing 2200, the main circuit board 2300, and the battery 2400, refer to the foregoing first embodiment.

The foregoing descriptions are only some embodiments and implementations of this application, and are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An integrated circuit board, comprising a flexible circuit board, a first electrical component, a second electrical component, a connecting member, a reinforcing plate, and a packaging member; wherein the flexible circuit board comprises a body part and an extension part that are connected in a length direction of the integrated circuit board;
the first electrical component and the second electrical component are respectively disposed on two sides of the body part that are opposite in a thickness direction of the integrated circuit board; the connecting member and the reinforcing plate are respectively disposed on two sides of the extension part that are opposite in the thickness direction of the integrated circuit board; and in the thickness direction of the integrated circuit board, a projection of the reinforcing plate on the extension part and a projection of the connecting member on the extension part overlap at least partially; and
the packaging member is fastened to the body part, the packaging member completely covers the first electrical component, and in the thickness direction of the integrated circuit board, both a projection of the second electrical component and a projection of the body part are completely located on the packaging member.

2. The integrated circuit board according to claim 1, wherein the packaging member is fastened to the body part in a molding manner.

3. The integrated circuit board according to claim 2, wherein there are at least two first electrical components, and the packaging member completely covers the at least two first electrical components.

4. The integrated circuit board according to claim 3, wherein the body part has a first bearing surface, both the first electrical component and the packaging member are fastened to the first bearing surface, the packaging member comprises a first package surface and a second package surface that are opposite in the thickness direction of the integrated circuit board, and the first package surface is fixedly connected to the first bearing surface; and
in the at least two first electrical components, a first electrical component with the largest thickness comprises an upper surface and a lower surface that are opposite in the thickness direction of the integrated circuit board, the lower surface is fixedly connected to the first bearing surface, and in the thickness direction of the integrated circuit board, a distance between the upper surface and the second package surface is greater than or equal to 0.05 mm and less than 0.3 mm.

5. The integrated circuit board according to claim 3, wherein in the at least two first electrical components, a first electrical component with the largest width comprises a front surface and a rear surface that are opposite in a width direction of the integrated circuit board; and the packaging member comprises a first package side and a second package side that are opposite in the width direction of the integrated circuit board; and
in the width direction of the integrated circuit board, a distance between the front surface and the first package side is greater than or equal to 0.1 mm and less than 0.6 mm; and a distance between the rear surface and the second package side is greater than or equal to 0.1 mm and less than 0.6 mm.

6. The integrated circuit board according to claim 3, wherein the packaging member comprises a first package end and a second package end that are opposite in a length direction of the integrated circuit board; and in the at least two first electrical components, the first electrical component closest to the first package end has a left side surface, and the first electrical component closest to the second package end has a right side surface; and
in the length direction of the integrated circuit board, a distance between the left side surface and the first package end is greater than or equal to 0.1 mm and less than 0.6 mm; and a distance between the right side surface and the second package end is greater than or equal to 0.1 mm and less than 0.6 mm.

7. The integrated circuit board according to any one of claims 1 to 6, wherein the extension part comprises a second bearing surface, and the second bearing surface and the first bearing surface are connected in the length direction of the integrated circuit board; and the packaging member comprises a second package end, the second bearing surface is adjacent to the second package end, and there is an included angle between the second bearing surface and the second package end; and
the integrated circuit board further comprises an adhesive, one side of the adhesive is bonded to the second bearing surface, and the other side of the adhesive is bonded to the second package end.

8. The integrated circuit board according to any one of claims 1 to 6, wherein the extension part comprises two extension sections that are connected at an angle, wherein an end of one of the extension sections is fixedly connected to the body part, and the connecting member and the reinforcing plate are disposed at an end of the other of the extension sections.

9. The integrated circuit board according to any one of claims 1 to 6, wherein the extension part comprises a first extension part and a second extension part, and the first extension part and the second extension part are respectively fastened on two sides of the body part that are opposite in the length direction of the integrated circuit board; and the reinforcing plate comprises a first reinforcing plate and a second reinforcing plate, and the connecting member comprises a first connecting member and a second connecting member;
the first connecting member and the first reinforcing plate are respectively disposed on two sides of the first extension part that are opposite in the thickness direction of the integrated circuit board; and the second connecting member and the second reinforcing plate are respectively disposed on two sides of the second extension part that are opposite in the thickness direction of the integrated circuit board; and
in the thickness direction of the integrated circuit board, a projection of the first reinforcing plate on the first extension part and a projection of the first connecting member on the first extension part overlap at least partially; and a projection of the second reinforcing plate on the second extension part and a projection of the second connecting member on the second extension part overlap at least partially.

10. A battery module, comprising a battery and the integrated circuit board according to any one of claims 1 to 9, wherein the battery has a positive tab and a negative tab, the integrated circuit board is disposed at an end of the battery, the positive tab and the negative tab are fixedly connected to the second electrical component, the positive tab and the negative tab are electrically connected to the second electrical component, the second electrical component is electrically connected to the first electrical component, and the first electrical component is electrically connected to the connecting member.

11. An electronic device, comprising a housing, a main circuit board, and the battery module according to claim 10, wherein both the main circuit board and the battery module are disposed inside the housing; a plug connector is disposed on the main circuit board, and the connecting piece and the plug connector are connected to each other, so that the positive tab, the integrated circuit board, the main circuit board, and the negative tab form a conductive loop.

12. An integrated circuit board preparation method, used to prepare the integrated circuit board according to any one of claims 1 to 9, comprising:
providing a flexible substrate, wherein the flexible substrate comprises the flexible circuit board;
fastening an auxiliary reinforcing plate to the body part, so that a projection of the body part is completely located on the auxiliary reinforcing plate in a thickness direction of the integrated circuit board;
fastening the first electrical component to the body part, and fastening the connecting member to an extension part;
fastening the packaging member to the body part, so that the packaging member completely covers the first electrical component;
peeling the auxiliary reinforcing plate off from the body part; and
fastening the second electrical component to the body part.

13. The integrated circuit board preparation method according to claim 12, wherein the fastening the packaging member to the body part specifically comprises: placing a mold on the flexible substrate, to enable a side that is of the body part and on which the first electrical component is disposed to be located inside the mold; and placing a raw material in the mold, heating the raw material, to enable the raw material to become a liquid material, and cooling the liquid material to form the packaging member.

14. The integrated circuit board preparation method according to claim 12 or 13, wherein the flexible substrate further comprises a redundant plate, and the redundant plate is formed integrally with the flexible circuit board; and the fastening an auxiliary reinforcing plate to the body part specifically comprises: bonding the auxiliary reinforcing plate to the redundant plate by using an adhesive.

15. The integrated circuit board preparation method according to claim 14, wherein the flexible substrate comprises a plurality of flexible circuit boards; and after the fastening the second electrical component to the body part, the integrated circuit board preparation method further comprises: cutting the flexible substrate, and after the redundant plate is removed, forming a plurality of integrated circuit boards.

16. An integrated circuit board, comprising a flexible circuit board, a first electrical component, and a packaging member; wherein the first electrical component is disposed on a surface of a side of the flexible circuit board; the packaging member is fastened to the flexible circuit board, and the packaging member completely covers the first electrical component; and in a thickness direction of the integrated circuit board, a projection of the flexible circuit board is completely located on the packaging member.

17. The integrated circuit board according to claim 16, wherein the packaging member is fastened to the flexible circuit board in a molding manner.

18. The integrated circuit board according to claim 16, wherein there are at least two first electrical components, and the packaging member completely covers the at least two first electrical components.

19. The integrated circuit board according to claim 18, wherein the flexible circuit board has a first surface; both the first electrical component and the packaging member are fastened to the first surface; and the packaging member comprises a first package surface and a second package surface that are opposite in the thickness direction of the integrated circuit board, and the first package surface is fixedly connected to the first surface; and
in the at least two first electrical components, a first electrical component with the largest thickness comprises an upper surface and a lower surface that are opposite in the thickness direction of the integrated circuit board, the lower surface is fixedly connected to the first surface, and in the thickness direction of the integrated circuit board, a distance between the upper surface and the second package surface is greater than or equal to 0.05 mm and less than 0.3 mm.

20. The integrated circuit board according to claim 18, wherein in the at least two first electrical components, a first electrical component with the largest width comprises a front surface and a rear surface that are opposite in a width direction of the integrated circuit board; and the packaging member comprises a first package side and a second package side that are opposite in the width direction of the integrated circuit board; and
in the width direction of the integrated circuit board, a distance between the front surface and the first package side is greater than or equal to 0.1 mm and less than 0.6 mm; and a distance between the rear surface and the second package side is greater than or equal to 0.1 mm and less than 0.6 mm.

21. The integrated circuit board according to claim 18, wherein the packaging member comprises a first package end and a second package end that are opposite in a length direction of the integrated circuit board; and in the at least two first electrical components, the first electrical component closest to the first package end has a left side surface, and the first electrical component closest to the second package end has a right side surface; and
in the length direction of the integrated circuit board, a distance between the left side surface and the first package end is greater than or equal to 0.1 mm and less than 0.6 mm; and a distance between the right side surface and the second package end is greater than or equal to 0.1 mm and less than 0.6 mm.

22. The integrated circuit board according to any one of claims 16 to 21, wherein the integrated circuit board further comprises a second electrical component, and the second electrical component is fastened to a surface of a side of the flexible circuit board that is away from the first electrical component.

23. An integrated circuit board preparation method, used to prepare the integrated circuit board according to any one of claims 16 to 21, comprising:
providing a flexible substrate, wherein the flexible substrate comprises the flexible circuit board;
fastening an auxiliary reinforcing plate to the flexible circuit board, so that a projection of the flexible circuit board is completely located on the auxiliary reinforcing plate in a thickness direction of the integrated circuit board;
fastening the first electrical component to the flexible circuit board;
fastening the packaging member to the flexible printed circuit, so that the packaging member completely covers the first electrical component; and
peeling the auxiliary reinforcing plate off from the flexible circuit board.

24. The integrated circuit board preparation method according to claim 23, wherein the fastening the packaging member to the flexible circuit board specifically comprises: placing a mold on the flexible substrate, to enable a side that is of the flexible circuit board and on which the first electrical component is disposed to be located inside the mold; and placing a raw material in the mold, heating the raw material, to enable the raw material to become a liquid material, and cooling the liquid material to form the packaging member.

25. The integrated circuit board preparation method according to claim 23 or 24, wherein the flexible substrate further comprises a redundant plate, and the redundant plate is formed integrally with the flexible circuit board; and the fastening an auxiliary reinforcing plate to the flexible circuit board specifically comprises: bonding the auxiliary reinforcing plate to the redundant plate by using an adhesive.

26. The integrated circuit board preparation method according to claim 25, wherein after the peeling the auxiliary reinforcing plate off from the flexible circuit board, the integrated circuit board preparation method further comprises: fastening a second electrical component to a surface of a side of the flexible circuit board that is away from the first electrical component; the flexible substrate comprises a plurality of flexible circuit boards; and after the second electrical component is fastened to the flexible circuit board, the integrated circuit board preparation method further comprises: cutting the flexible substrate, and removing the redundant plate to form a plurality of integrated circuit boards.

27. An integrated circuit board, comprising a flexible circuit board, a first electrical component, a second electrical component, a connecting member, a reinforcing plate, and a packaging member, wherein the flexible circuit board comprises a body part and an extension part that are connected in a length direction of the integrated circuit board;
the first electrical component and the second electrical component are respectively disposed on two sides of the body part that are opposite in a thickness direction of the integrated circuit board; the connecting member and the reinforcing plate are respectively disposed on two sides of the extension part that are opposite in the thickness direction of the integrated circuit board; and in the thickness direction of the integrated circuit board, a projection of the reinforcing plate on the extension part and a projection of the connecting member on the extension part overlap at least partially;
the packaging member is fastened to the body part, the packaging member completely covers the first electrical component, and in the thickness direction of the integrated circuit board, both a projection of the second electrical component and a projection of the body part are completely located on the packaging member;
the extension part comprises a second bearing surface; the packaging member comprises a second package end, the second bearing surface is adjacent to the second package end, and there is an included angle between the second bearing surface and the second package end; and
the integrated circuit board further comprises an adhesive, the adhesive has a regular shape, the adhesive has two adhesive surfaces, one adhesive surface of the adhesive is bonded to the second bearing surface, and the other adhesive surface of the adhesive is bonded to the second package end.

28. The integrated circuit board according to claim 27, wherein the packaging member is fastened to the body part in a molding manner.

29. The integrated circuit board according to claim 28, wherein there are at least two first electrical components, and the packaging member completely covers the at least two first electrical components.

30. The integrated circuit board according to claim 29, wherein the body part has a first bearing surface, both the first electrical component and the packaging member are fastened to the first bearing surface, the packaging member comprises a first package surface and a second package surface that are opposite in the thickness direction of the integrated circuit board, and the first package surface is fixedly connected to the first bearing surface; and
in the at least two first electrical components, a first electrical component with the largest thickness comprises an upper surface and a lower surface that are opposite in the thickness direction of the integrated circuit board, the lower surface is fixedly connected to the first bearing surface, and in the thickness direction of the integrated circuit board, a distance between the upper surface and the second package surface is greater than or equal to 0.05 mm and less than 0.3 mm.

31. The integrated circuit board according to claim 29, wherein in the at least two first electrical components, a first electrical component with the largest width comprises a front surface and a rear surface that are opposite in a width direction of the integrated circuit board; and the packaging member comprises a first package side and a second package side that are opposite in the width direction of the integrated circuit board; and
in the width direction of the integrated circuit board, a distance between the front surface and the first package side is greater than or equal to 0.1 mm and less than 0.6 mm; and a distance between the rear surface and the second package side is greater than or equal to 0.1 mm and less than 0.6 mm.

32. The integrated circuit board according to claim 29, wherein the packaging member comprises a first package end and a second package end that are opposite in a length direction of the integrated circuit board; and in the at least two first electrical components, the first electrical component closest to the first package end has a left side surface, and the first electrical component closest to the second package end has a right side surface; and
in the length direction of the integrated circuit board, a distance between the left side surface and the first package end is greater than or equal to 0.1 mm and less than 0.6 mm; and a distance between the right side surface and the second package end is greater than or equal to 0.1 mm and less than 0.6 mm.

33. The integrated circuit board according to any one of claims 27 to 32, wherein the extension part comprises two extension sections that are connected at an angle, wherein an end of one of the extension sections is fixedly connected to the body part, and the connecting member and the reinforcing plate are disposed at an end of the other of the extension sections.

34. The integrated circuit board according to any one of claims 27 to 32, wherein the extension part comprises a first extension part and a second extension part, and the first extension part and the second extension part are respectively fastened on two sides of the body part that are opposite in the length direction of the integrated circuit board; and the reinforcing plate comprises a first reinforcing plate and a second reinforcing plate, and the connecting member comprises a first connecting member and a second connecting member;
the first connecting member and the first reinforcing plate are respectively disposed on two sides of the first extension part that are opposite in the thickness direction of the integrated circuit board; and the second connecting member and the second reinforcing plate are respectively disposed on two sides of the second extension part that are opposite in the thickness direction of the integrated circuit board; and
in the thickness direction of the integrated circuit board, a projection of the first reinforcing plate on the first extension part and a projection of the first connecting member on the first extension part overlap at least partially; and a projection of the second reinforcing plate on the second extension part and a projection of the second connecting member on the second extension part overlap at least partially.
